(19) 

**Europäisches Patentamt**
**European Patent Office**
**Office européen des brevets**

(11)  **EP 4 730 389 A1**

(12)  # EUROPEAN PATENT APPLICATION
published in accordance with Art. 153(4) EPC

(43) Date of publication:
**22.04.2026  Bulletin 2026/17**

(21) Application number: **24882842.8**

(22) Date of filing: **24.10.2024**

(51) International Patent Classification (IPC):
**H01J 37/32** (2006.01)       **H03K 5/135** (2006.01)
**H03K 5/1534** (2006.01)

(52) Cooperative Patent Classification (CPC):
**H01J 37/32; H03K 5/135; H03K 5/1534**

(86) International application number:
**PCT/KR2024/016248**

(87) International publication number:
**WO 2025/089815 (01.05.2025 Gazette 2025/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **27.10.2023   KR 20230145506**

(71) Applicant: **EN2CORE technology, Inc**
**Daejeon 34127 (KR)**

(72) Inventors:
  • **SOHN, Yeong Hoon**
    **Daejeon 34050 (KR)**

  • **PARK, Se-Hong**
    **Daejeon 35200 (KR)**
  • **THAI, Xuan Van**
    **Daejeon 34007 (KR)**
  • **JEGAL, Dong**
    **Daejeon 34127 (KR)**
  • **HUH, Jin**
    **Daejeon 34032 (KR)**
  • **KIM, Hyeonseok**
    **Daejeon 34107 (KR)**

(74) Representative: **Walaski, Jan Filip**
**Venner Shipley LLP**
**200 Aldersgate**
**London EC1A 4HD (GB)**

(54)  **FREQUENCY CONTROL METHOD FOR PRECISELY CONTROLLING FREQUENCY AND FREQUENCY CONTROL DEVICE USING SAME**

(57)    The present disclosure discloses that A frequency control apparatus of control a frequency of AC voltage applied to a load according to a variable resonant frequency of the load. The apparatus comprises: an inverter having at least two switches electrically interposed between terminals electrically connected to the load and a DC power source, the inverter applies the AC voltage to the load through the terminals, wherein the AC voltage has a frequency determined by an operation of the at least two switches; and a controller having a processor, the controller generates a control signal controlling the operation of the at least two switches based on a clock of the processor, wherein the controller is configured to: output a first control signal controlling the at least two switches such that a first AC voltage having a first frequency is applied to the load during a first duration, assume a wave of a virtual signal corresponding to the first frequency by shifting a wave of the first control signal by a predetermined time, determine a delay time between the wave of the virtual signal and a wave of an output current of the inverter of the first duration in at least part of the first duration based on the clock, determine a second frequency based on (i) the first frequency, (ii) the delay time and (iii) at least one output-possible frequency that can be determined using the clock, and output a second control signal controlling the at least two switches such that a second AC voltage having a second frequency is applied to the load during a second duration immediately after the first duration.

FIG. 3

## Description

### [Field of the Invention]

The present disclosure relates to a frequency control method for precisely controlling a frequency and a frequency control apparatus using the same and, more particularly, to a frequency control apparatus and a control method thereof, wherein an output frequency of an AC voltage is precisely controlled according to an impedance change of a variable load in order to maximize energy transfer efficiency when the AC voltage is provided to the variable load whose impedance changes over time, and the AC voltage having the precisely controlled frequency is output to the load.

### [Description of the Related Art]

Technology utilizing plasma is used in various industrial fields including technology fields for semiconductor, display, and medical equipment, environmental technology fields for air, water, soil purification, etc., and energy technology fields for solar cells, hydrogen energy, etc.

There are many methods to generate such plasma, the methods including a method for direct current discharges such as corona discharge, glow discharge, and arc discharge, a method for alternating current discharges such as capacitive coupled discharge and inductive coupled discharge, and a method for shock waves, high-energy beams, etc. Among these methods, the inductive coupling method utilizing a simple configuration to have high usability is attracting attention.

Meanwhile, in order to efficiently generate plasma, it is preferable to apply, to a load, an AC voltage having a frequency identical to or similar to a resonant frequency of the load that generates the plasma.

However, the resonant frequency of the load may continuously change as plasma is generated, so there is a problem in that it is difficult to control a frequency of an AC voltage applied to the load in real time in response to such a frequency change. Therefore, in order to generate and maintain stable plasma, there is required a method for precisely controlling a frequency of an AC voltage so that the frequency of the AC voltage applied to the load may be tracked as closely as possible to the resonant frequency of the variable load.

### [Disclosure]

### [Technical Problem]

An objective of the present disclosure for solving the problem is to provide a frequency control method and an apparatus using the same for changing a frequency of an AC voltage provided to a load.

An objective of the present disclosure for solving the problem is to provide a frequency control method and an apparatus using the same configured to predict an output voltage that is output from an inverter, and change a frequency of an AC voltage provided to a load in real time on the basis of a delay time between the predicted output voltage and an output current of the load.

An objective of the present disclosure for solving the problem is to provide a frequency control method and an apparatus using the same configured to determine how much to change a frequency of an AC voltage when the frequency of the AC voltage provided to a load is changed, and change the frequency of the AC voltage accordingly.

An objective of the present disclosure for solving the problem is to provide a frequency control method and an apparatus using the same configured to use a plurality of frequencies to generate a frequency closest to a frequency of an AC voltage determined to be changed when the frequency of the AC voltage determined to be changed is unable to be generated through a clock of a processor of a frequency control apparatus.

Technical solutions of the present disclosure may not be limited to the above, and other technical solutions which are not described herein should be clearly understood by those skilled in the art, to which the present disclosure belongs, from the present specification and the accompanying drawings.

### [Technical Solution]

The present disclosure discloses that A frequency control apparatus of control a frequency of AC voltage applied to a load according to a variable resonant frequency of the load. The apparatus comprises: an inverter having at least two switches electrically interposed between terminals electrically connected to the load and a DC power source, the inverter applies the AC voltage to the load through the terminals, wherein the AC voltage has a frequency determined by an operation of the at least two switches; and a controller having a processor, the controller generates a control signal controlling the operation of the at least two switches based on a clock of the processor, wherein the controller is configured to: output a first control signal controlling the at least two switches such that a first AC voltage having a first frequency is applied to the load during a first duration, assume a wave of a virtual signal corresponding to the first frequency by shifting a wave of the first control signal by a predetermined time, determine a delay time between the wave of the virtual signal and a wave of an output current of the inverter of the first duration in at least part of the first duration based on the clock, determine a second frequency based on (i) the first frequency, (ii) the delay time and (iii) at least one output-possible frequency that can be determined using the clock, and output a second control signal controlling the at least two switches such that a second AC voltage having a second frequency is applied to the load during a second duration immediately after the first duration.

Herein, the delay time is different value between a first count value and a second count value, wherein the first count value obtained by counting a first time length from a rising edge of the wave of the virtual signal to a falling edge of the wave of the virtual signal being firstly occurred after the rising edge, according to the clock, and wherein the second count value obtained by counting a second time length from the rising edge to a falling edge of the wave of the output current being firstly occurred after the rising edge, according to the clock.

Furthermore, the second frequency is increased from the first frequency when the delay time is greater than a first value, wherein the second frequency is decreased from the first frequency when the delay time is less than a second value, wherein the second frequency is the same with the first frequency when the delay time has value between the first value and the second value, and wherein the first value and the second value are the same or different.

Furthermore, the predetermined time is the same with time difference between a first time point at which the wave of the first control signal is input to the inverter and a second time point at which the wave of the first control signal is expected to be output from the inverter.

Furthermore, the predetermined time is less than or greater than time difference between a first time point at which the wave of the first control signal is input to the inverter and a second time point at which the wave of the first control signal is expected to be output from the inverter.

Furthermore, the controller is configured to: determine the second frequency based on multiplying a difference value between the first frequency and an adjacent frequency to the first frequency among the at least one output-possible frequency by a factor, wherein the factor is determined based on the delay time.

Furthermore, the controller is configured to: determine the delay time based on an average value of a last N delay time among delay times between the wave of the output current and the wave of the virtual signal, both of which can be obtained during the first duration.

Furthermore, when the second frequency is not included in the at least one output-possible frequency, the controller is configured to, determine difference values between each of a plurality of output-possible frequencies closest to the second frequency among the at least one output-possible frequency and the second frequency, and output a plurality of third control signals, instead of the second control signal, corresponding to each of the plurality of output-possible frequencies according to output counts for each of the plurality of output-possible frequencies, and wherein the output counts are determined based on a ratio between the difference values.

Furthermore, the controller is configured to: output the plurality of third control signals such that a dispersion among the plurality of third control signals is uniformly distributed according to the output counts for each of the plurality of output-possible frequencies.

The present disclosure discloses that a frequency control method of control a frequency of AC voltage applied to a load according to a variable resonant frequency of the load by a frequency control apparatus. The method comprises: outputting a first control signal controlling such that a first AC voltage having a first frequency is applied to the load during a first duration, assuming a wave of a virtual signal corresponding to the first frequency by shifting a wave of the first control signal by a predetermined time, determining a delay time between the wave of the virtual signal and a wave of an output current of the inverter of the first duration in at least part of the first duration based on a clock corresponding to the frequency control apparatus, determining a second frequency based on (i) the first frequency, (ii) the delay time and (iii) at least one output-possible frequency that can be determined using the clock, and outputting a second control signal controlling such that a second AC voltage having a second frequency is applied to the load during a second duration immediately after the first duration.

Herein, the delay time is different value between a first count value and a second count value, wherein the first count value obtained by counting a first time length from a rising edge of the wave of the virtual signal to a falling edge of the wave of the virtual signal being firstly occurred after the rising edge, according to the clock, and wherein the second count value obtained by counting a second time length from the rising edge to a falling edge of the wave of the output current being firstly occurred after the rising edge, according to the clock.

Furthermore, the second frequency is increased from the first frequency when the delay time is greater than a first value, wherein the second frequency is decreased from the first frequency when the delay time is less than a second value, wherein the second frequency is the same with the first frequency when the delay time has value between the first value and the second value, and wherein the first value and the second value are the same or different.

Furthermore, the predetermined time is the same with time difference between a first time point at which the wave of the first control signal is input to the inverter and a second time point at which the wave of the first control signal is expected to be output from the inverter.

Furthermore, the predetermined time is less than or greater than time difference between a first time point at which the wave of the first control signal is input to the inverter and a second time point at which the wave of the first control signal is expected to be output from the inverter.

Furthermore, the determining the second frequency comprises: determining the second frequency based on multiplying a difference value between the first frequency and an adjacent frequency to the first frequency among the at least one output-possible frequency by a factor, wherein the factor is determined based on the delay time.

Furthermore, the determining the delay time comprises: determining the delay time based on an average value of a last N delay time among delay times between the wave of the output current and the wave of the virtual signal, both of which can be obtained during the first duration.

Furthermore, the method further comprises: when the second frequency is not included in the at least one output-possible frequency, determining difference values between each of a plurality of output-possible frequencies closest to the second frequency among the at least one output-possible frequency and the second frequency, and outputting a plurality of third control signals, instead of the second control signal, corresponding to each of the plurality of output-possible frequencies according to output counts for each of the plurality of output-possible frequencies, and wherein the output counts are determined based on a ratio between the difference values.

Furthermore, the outputting the plurality of third control signals comprises: outputting the plurality of third control signals such that a dispersion among the plurality of third control signals is uniformly distributed according to the output counts for each of the plurality of output-possible frequencies.

**[Advantageous Effects]**

According to the present disclosure, plasma generation may be induced and the generated plasma may be maintained by applying an AC voltage having an appropriate frequency to a variable load.

According to the present disclosure, a frequency of an AC voltage applied to a load may be controlled so as to correspond to a resonant frequency of the variable load, thereby stably maintaining plasma generated from the load.

According to the present disclosure, by determining how much to change a frequency of an AC voltage applied to a load and using a plurality of frequencies, a frequency closest to the frequency of the corresponding AC voltage is generated, whereby plasma maintenance capacity may be improved.

Effects of the present disclosure may not be limited to the above, and other effects which are not described herein should be clearly understood by those skilled in the art, to which the present disclosure belongs, from the present specification and the accompanying drawings.

**[BRIEF DESCRIPTION OF THE DRAWINGS]**

FIG. 1 is a view illustrating a plasma system according to an exemplary embodiment of the present specification.

FIG. 2 is a view illustrating an RF generator according to the exemplary embodiment of the present specification.

FIG. 3 is a view illustrating a structure of the RF generator for frequency control according to the exemplary embodiment of the present specification.

FIG. 4 is a view illustrating a relationship between a signal (of control or output current) and a wave of (a control signal or output current) in the exemplary embodiment of the present specification.

FIG. 5 is a view illustrating a reason why a delay time occurs according to the exemplary embodiment of the present specification.

FIG. 6 is a view illustrating the necessity of a method of controlling a frequency according to the exemplary embodiment of the present specification.

FIG. 7 is a view illustrating a method of controlling a frequency according to the exemplary embodiment of the present specification.

FIG. 8 is a view illustrating various examples of assuming waves of virtual signals according to the exemplary embodiment of the present specification.

FIGS. 9 is views illustrating processes in which a resonant frequency changes and illustrating effects thereof in each of various examples assuming the waves of the virtual signals according to the exemplary embodiment of the present specification.

FIG. 10 is a view illustrating a discharge stabilization effect in a case where a capacitive mode is used, among the various examples assuming the waves of the virtual signals according to the exemplary embodiment of the present specification.

FIGS. 11 and 12 are views illustrating a method of generating an AC voltage having a frequency close to a resonant frequency of a variable load according to the exemplary embodiment of the present specification.

FIGS. 13 and 14 are views illustrating an effect of the method of generating the AC voltage having the frequency close to the resonant frequency of the variable load described above according to the exemplary embodiment of the present specification.

FIGS. 15 and 20 are views illustrating a method of generating an AC voltage having a frequency close to a resonant frequency of a variable load according to another exemplary embodiment of the present specification.

FIG 21 is a view illustrating an effect of the method of generating the AC voltage having the frequency close to the resonant frequency of the variable load described above according to another exemplary embodiment of the present specification.

**[DETAILED DESCRIPTION OF THE INVENTION]**

The above-described objectives, characteristics, and advantages of the present disclosure will be more apparent by the following detailed description with reference to the accompanying drawings. Since the present disclosure may be variously modified and have various embodiments, specific embodiments will be shown in the accompanying drawings and described in detail in a detailed description.

Embodiments described in this specification are made to clearly explain the scope of the present disclosure to those having ordinary skill in the art and are not intended to limit the present disclosure. It should be interpreted that the present disclosure may include substitutions and modifications within the technical scope of the present disclosure.

The accompanying drawings are to facilitate the explanation of the present disclosure and the shape in the drawings may be exaggerated for the purpose of convenience of explanation, so the present disclosure should not be limited to the drawings.

Moreover, detailed descriptions about well-known functions or configurations associated with the present disclosure will be ruled out in order to not unnecessarily obscure the essence of the present disclosure. It should also be noted that, although ordinal numbers (such as first and second) are used in the following description, they are used only to distinguish similar components.

In addition, the terms "module", "unit", and "parts" for elements used in the following description are given or used interchangeably only for facilitation of preparing this specification, and thus they are not granted a specific meaning or function.

The present disclosure discloses that A frequency control apparatus of control a frequency of AC voltage applied to a load according to a variable resonant frequency of the load. The apparatus comprises: an inverter having at least two switches electrically interposed between terminals electrically connected to the load and a DC power source, the inverter applies the AC voltage to the load through the terminals, wherein the AC voltage has a frequency determined by an operation of the at least two switches; and a controller having a processor, the controller generates a control signal controlling the operation of the at least two switches based on a clock of the processor, wherein the controller is configured to: output a first control signal controlling the at least two switches such that a first AC voltage having a first frequency is applied to the load during a first duration, assume a wave of a virtual signal corresponding to the first frequency by shifting a wave of the first control signal by a predetermined time, determine a delay time between the wave of the virtual signal and a wave of an output current of the inverter of the first duration in at least part of the first duration based on the clock, determine a second frequency based on (i) the first frequency, (ii) the delay time and (iii) at least one output-possible frequency that can be determined using the clock, and output a second control signal controlling the at least two switches such that a second AC voltage having a second frequency is applied to the load during a second duration immediately after the first duration.

Herein, the delay time is different value between a first count value and a second count value, wherein the first count value obtained by counting a first time length from a rising edge of the wave of the virtual signal to a falling edge of the wave of the virtual signal being firstly occurred after the rising edge, according to the clock, and wherein the second count value obtained by counting a second time length from the rising edge to a falling edge of the wave of the output current being firstly occurred after the rising edge, according to the clock.

Furthermore, the second frequency is increased from the first frequency when the delay time is greater than a first value, wherein the second frequency is decreased from the first frequency when the delay time is less than a second value, wherein the second frequency is the same with the first frequency when the delay time has value between the first value and the second value, and wherein the first value and the second value are the same or different.

Furthermore, the predetermined time is the same with time difference between a first time point at which the wave of the first control signal is input to the inverter and a second time point at which the wave of the first control signal is expected to be output from the inverter.

Furthermore, the predetermined time is less than or greater than time difference between a first time point at which the wave of the first control signal is input to the inverter and a second time point at which the wave of the first control signal is expected to be output from the inverter.

Furthermore, the controller is configured to: determine the second frequency based on multiplying a difference value between the first frequency and an adjacent frequency to the first frequency among the at least one output-possible frequency by a factor, wherein the factor is determined based on the delay time.

Furthermore, the controller is configured to: determine the delay time based on an average value of a last N delay time among delay times between the wave of the output current and the wave of the virtual signal, both of which can be obtained during the first duration.

Furthermore, when the second frequency is not included in the at least one output-possible frequency, the controller is configured to, determine difference values between each of a plurality of output-possible frequencies closest to the second frequency among the at least one output-possible frequency and the second frequency, and output a plurality of third control signals, instead of the second control signal, corresponding to each of the plurality of output-possible frequencies according to output counts for each of the plurality of output-possible frequencies, and wherein the output counts are determined based on a ratio between the difference values.

Furthermore, the controller is configured to: output the plurality of third control signals such that a dispersion among the plurality of third control signals is uniformly distributed according to the output counts for each of the plurality of output-possible frequencies.

The present disclosure discloses that a frequency control method of control a frequency of AC voltage applied to a load according to a variable resonant frequency of the load by a frequency control apparatus. The method comprises: outputting a first control signal controlling such that a first AC voltage having a first frequency is applied to the load during a first duration, assuming a wave of a virtual signal corresponding to the first frequency by shifting a wave of the first control signal by a predetermined time, determining a delay time between the wave of the virtual signal and a wave of an output current of the inverter of the first duration in at least part of the first duration based on a clock corresponding to the frequency control apparatus, determining a second frequency based on (i) the first frequency, (ii) the delay time and (iii) at least one output-possible frequency that can be determined using the clock, and outputting a second control signal controlling such that a second AC voltage having a second frequency is applied to the load during a second duration immediately after the first duration.

Herein, the delay time is different value between a first count value and a second count value, wherein the first count value obtained by counting a first time length from a rising edge of the wave of the virtual signal to a falling edge of the wave of the virtual signal being firstly occurred after the rising edge, according to the clock, and wherein the second count value obtained by counting a second time length from the rising edge to a falling edge of the wave of the output current being firstly occurred after the rising edge, according to the clock.

Furthermore, the second frequency is increased from the first frequency when the delay time is greater than a first value, wherein the second frequency is decreased from the first frequency when the delay time is less than a second value, wherein the second frequency is the same with the first frequency when the delay time has value between the first value and the second value, and wherein the first value and the second value are the same or different.

Furthermore, the predetermined time is the same with time difference between a first time point at which the wave of the first control signal is input to the inverter and a second time point at which the wave of the first control signal is expected to be output from the inverter.

Furthermore, the predetermined time is less than or greater than time difference between a first time point at which the wave of the first control signal is input to the inverter and a second time point at which the wave of the first control signal is expected to be output from the inverter.

Furthermore, the determining the second frequency comprises: determining the second frequency based on multiplying a difference value between the first frequency and an adjacent frequency to the first frequency among the at least one output-possible frequency by a factor, wherein the factor is determined based on the delay time.

Furthermore, the determining the delay time comprises: determining the delay time based on an average value of a last N delay time among delay times between the wave of the output current and the wave of the virtual signal, both of which can be obtained during the first duration.

Furthermore, the method further comprises: when the second frequency is not included in the at least one output-possible frequency, determining difference values between each of a plurality of output-possible frequencies closest to the second frequency among the at least one output-possible frequency and the second frequency, and outputting a plurality of third control signals, instead of the second control signal, corresponding to each of the plurality of output-possible frequencies according to output counts for each of the plurality of output-possible frequencies, and wherein the output counts are determined based on a ratio between the difference values.

Furthermore, the outputting the plurality of third control signals comprises: outputting the plurality of third control signals such that a dispersion among the plurality of third control signals is uniformly distributed according to the output counts for each of the plurality of output-possible frequencies.

The present specification relates to a frequency control method for precisely controlling a frequency and a frequency control apparatus using the same.

Specifically, based on the frequency control method and the frequency control apparatus using the same according to the exemplary embodiment of the present specification, when the frequency control apparatus applies voltage, current, or power, which has a specific frequency to a load, the frequency control apparatus may change the corresponding specific frequency periodically or aperiodically.

Here, the specific frequency means a frequency of voltage, current, or power, which is applied to a load, and may mean a driving frequency.

Here, the load may mean a component to which power is supplied. For example, the load may mean an electrical component including electrical elements such as a resistor, an inductor, or a capacitor. The load may have a resonant frequency depending on the electrical properties or characteristics of the electrical elements constituting the load. In this case, in a case where the electrical properties or characteristics of the load change over time, the resonant frequency of the load may change over time.

Hereinafter, for convenience of description, the frequency control method and the frequency control apparatus using the same in a plasma system are described, but the technical idea of the present specification is not limited thereto, and it is natural that the frequency control apparatus may be similarly applied to an apparatus or application, which is required to supply AC power by periodically or aperiodically controlling a specific frequency (e.g., a driving frequency). For example, in the fields of wireless power transmission, induction heating, etc., the frequency control method and the apparatus thereof using the same described below may be used in order to control a frequency of AC power so as to correspond to a variable resonant frequency of a load.

According to the exemplary embodiment of the present disclosure, the frequency control method may be used in order to apply power to an antenna or an antenna structure in a plasma system for generating and maintaining plasma.

Here, plasma is a phase in which matter is applied with high energy and separated into negatively charged electrons and positively charged ions, and the plasma may be induced or generated by various methods. Among these methods, inductively coupled plasma (ICP) is plasma, which is generated by way of supplying power to a coil, an antenna, or the like and forming an induced electric field or a capacitive electric field in a specific space, and is generally able to be driven by a high frequency power source such as radio frequency (RF). Meanwhile, for convenience of description, the following description assumes that plasma generated by a plasma system is the inductively coupled plasma. However, the technical idea of the present specification is not limited thereto.

Here, an antenna is an inductive element or load forming an electric field or a magnetic field therearound when voltage or current is applied thereto, and this antenna may mean a coil, an inductor, or the like and may further mean an equivalent circuit implemented with elements other than the inductive element.

Here, an antenna structure may mean a structure including at least one antenna. Furthermore, the antenna structure may include at least one or more capacitive elements or loads and may be implemented in a form in which at least one or more antennas or capacitive elements are connected or arranged in a specific manner.

Meanwhile, the plasma system according to the exemplary embodiment of the present specification may be widely used in various fields of semiconductors, display processing, environment, energy, etc. It should be noted in advance that a plasma generation device described below is not limited to being used in a specific field, but may be commonly used in the fields where plasma is utilized.

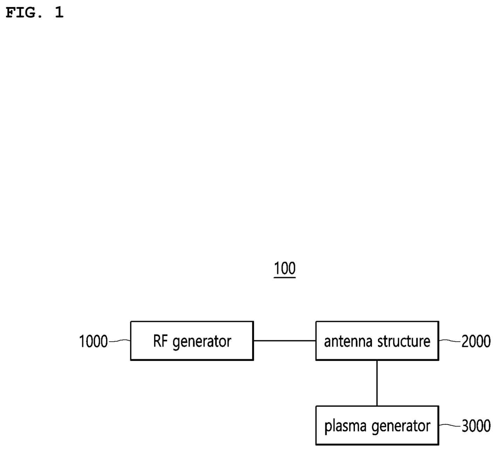

Hereinafter, a plasma system according to the exemplary embodiment of the present specification will be described with reference to FIG. 1.

FIG. 1 is a view illustrating a plasma system 100 according to the exemplary embodiment of the present specification. Referring to FIG. 1, the plasma system 100 may include a radio frequency (RF) generator 1000, an antenna structure 2000, and a plasma generator 3000. The plasma system 100 may induce inductive coupling plasma generation in the plasma generator 3000 by using the RF generator 1000 to supply RF AC voltage or RF AC current (or RF AC power accordingly) to the antenna structure 2000.

The RF generator 1000 may provide voltage, current, or power to the antenna structure 2000. For example, the RF generator 1000 may apply an AC voltage, a current, or power having a specific frequency (e.g., a driving frequency) to the antenna structure 2000. In this case, the frequency of the AC power, the frequency of the AC current, or the frequency of the AC voltage, which is provided to the antenna structure 2000, may be changed as described below.

Hereinafter, for convenience of description, it is described that an AC voltage having a frequency is applied to the antenna structure 2000 or the load, but those skilled in the art of the present disclosure may easily understand that an AC current or AC electric power having a frequency is applied to the antenna structure 2000 or the load in such a way.

The antenna structure 2000 may include at least one antenna. Alternatively, the antenna structure 2000 may include at least one antenna and at least one capacitor.

The antenna structure 2000 may be electrically connected to the RF generator 1000. The antenna structure 2000 may be connected in series or in parallel to the RF generator 1000 via wires, or may be connected in series or in parallel thereto via electrical components.

The antenna structure 2000 may be physically or electrically connected to the plasma generator 3000. Specific details regarding a connection relationship between the antenna structure 2000 and the plasma generator 3000 will be described below.

When the antenna structure 2000 receives RF power from the RF generator 1000, a current (i.e., an AC current) whose phases (or directions and magnitudes) vary over time flows through the antenna structure 2000, and on the basis of this, an induced electric field is generated in the plasma generator 3000, thereby inducing plasma.

The antenna structure 2000 may have a resonant frequency determined by the electrical properties and/or characteristics of components therein. Here, the resonant frequency is a resonant frequency determined by inductance and/or capacitance included in the antenna structure 2000, and may be defined as the resonant frequency of the antenna structure 2000.

Meanwhile, in the present disclosure, the resonant frequency of the load may also mean a resonant frequency of synthetic impedance in which the influence of the antenna structure 2000 and plasma is taken into account. For example, while the plasma is formed and maintained by the plasma system 100, a frequency that is to be applied from the RF generator 1000 to the antenna structure 2000 in order to minimize a phase difference between voltage and current applied to the load including the corresponding plasma and the antenna structure 2000 can vary over time. In this case, it may be seen that the synthetic impedance of plasma generated from the antenna structure 2000 and plasma generator 3000 (i.e., the synthetic impedance of the load including the antenna structure 2000 and the time-varying plasma) varies over time, whereby the resonant frequency of the load is changed.

The plasma generator 3000 may include an area or space where plasma generation is induced. Specifically, the plasma generator 3000 may refer to a space where plasma can be generated and maintained, such as a chamber or a tube.

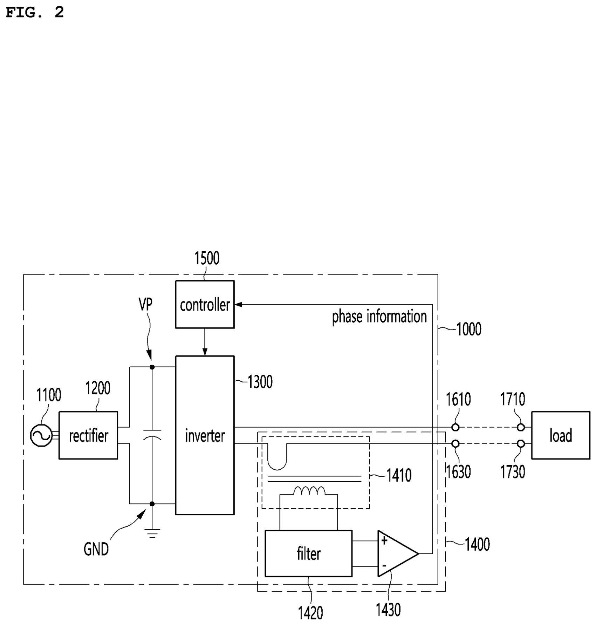

Hereinafter, a configuration and structure of the RF generator 1000 will be described with reference to FIG. 2.

FIG. 2 is a view illustrating an RF generator 1000 according to the exemplary embodiment of the present specification.

Referring to FIG. 2, the RF generator 1000 may include an AC power source 1100, a rectifier 1200, an inverter 1300, a controller 1500, and a sensor module 1400. The RF generator 1000 may convert an alternating current supplied from the AC power source 1100 into another alternating current and supply the converted alternating current to a load. For example, the RF generator 1000 may convert an alternating current used in typical households or industries into another alternating current having a frequency of several hundred kHz to several tens of MHz and power of several kW or more, and provide the converted alternating current to a load.

Meanwhile, the RF generator 1000 and the load may be electrically and/or physically connected to each other by one or more nodes. Referring to FIG. 2, two nodes 1610 and 1630 on the RF generator 1000 side and two nodes 1710 and 1730 on the load side may be electrically and/or physically connected. For example, the node 1610 may be connected to the node 1710, and the node 1630 may be connected to the node 1730. For example, the node 1610 may be connected to the node 1710 with a conducting wire, and the node 1630 may be connected to the node 1730 with another conducting wire.

Meanwhile, the nodes 1610, 1630, 1710, and 1730 may also be implemented in the form of terminals. In such a case, a terminal of the node 1610 and a terminal of the node 1710 may be connected to each other by a wire, cable, or connector, and a terminal of the node 1630 and a terminal of the node 1730 may be connected to each other by a wire, cable, or connector.

Hereinafter, for convenience of description, it is assumed that the RF generator 1000 and the load are connected to each other through the nodes 1610, 1630, 1710, and 1730. That is, for convenience of description, configurations of the nodes 1610, 1630, 1710, and 1730 may be omitted from the drawings or omitted from the specific description of the present specification, but it may be easily inferred from the above description and by those skilled in the art that the RF generator 1000 and the load are connected to each other through the nodes 1610, 1630, 1710, and 1730.

Here, the load may include the antenna structure 2000 and the plasma generated by the antenna structure 2000. In this case, impedance of the load becomes synthetic impedance of both the impedance of the antenna structure 2000 and the impedance of the plasma, and since the impedance of the plasma varies over time depending on states of the plasma, the load has a resonance frequency that varies over time depending on plasma induction.

The rectifier 1200 may convert the output of the AC power source 1100 into direct current (DC). The rectifier 1200 may convert alternating current supplied from the AC power source 1100 into direct current and apply the direct current to both ends of the inverter 1300 (e.g., input terminals of the inverter 1300).

The inverter 1300 may receive direct current from the rectifier 1200 and supply alternating current to the load. For example, the inverter 1300 may receive a control signal from the controller 1500 and provide an alternating current to the load by using the received control signal. Here, the inverter 1300 may include at least one switching element controlled by the control signal, and the alternating current supplied from the inverter 1300 to the load may have a specific frequency (e.g., a driving frequency) set on the basis of the control signal provided to the inverter 1300 from the controller 1500.

According to some exemplary embodiments disclosed by the present application, an inverter 1300 may be provided as a half bridge type or a full bridge type.

Meanwhile, a capacitive element may be arranged between the rectifier 1200 and the inverter 1300. For example, the RF generator 1000 includes a capacitor connected in parallel to the rectifier 1200 and the inverter 1300, and the capacitor may discharge the AC component of voltage or current applied to the inverter 1300 to a ground node (GND).

The controller 1500 may receive data sensed from a sensor module 1400 described below and generate a control signal. For example, the controller 1500 may be implemented to obtain resonant frequency-related data such as current and voltage of the load from the sensor module 1400, so as to generate the control signal. Specifically, the controller 1500 may use information about a wave of an output current output from the inverter 1300, the information being obtained from the sensor module 1400, so as to obtain a phase difference or a delay time with respect to a wave of a virtual signal that delays a wave of the control signal for converting a direct current voltage applied to the inverter 1300 into an alternating current voltage by a predetermined time, and the controller 1500 may generate a control signal for controlling a frequency of the alternating current voltage output from the inverter 1300 on the basis of the obtained phase difference or delay time. Here, the obtaining of the phase difference or delay time may mean detecting/sensing the phase difference or delay time. Hereinafter, it should be noted in advance that in the description of the present specification as well, the obtaining of the phase difference or delay time may be interpreted as detecting/sensing a phase difference or delay time.

The controller 1500 may be implemented by using Field Programmable Gate Arrays (FPGA) technology. The specific configuration and structure of the controller 1500 will be described below.

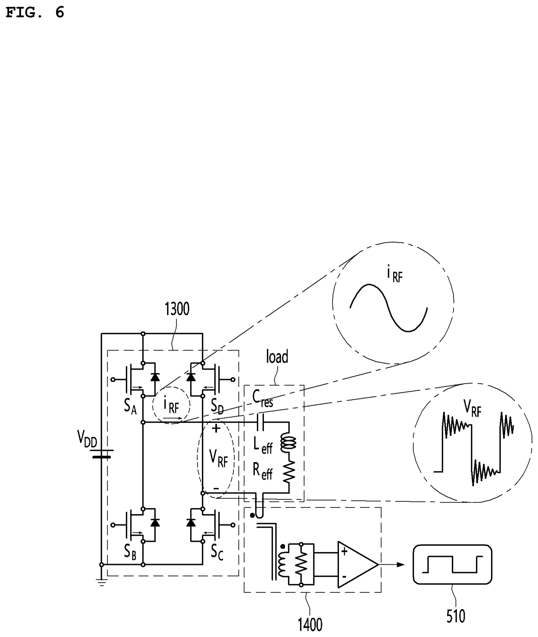

The output current wave sensed by the sensor module 1400 may be a signal or data with respect to directions of current applied to the load (i.e., current output from the inverter 1300) and time for which the current flows in each direction. That is, the output current wave may be a square wave signal as a digitized signal obtained by measuring the directions in which the current flows and the time for which the current flows in each corresponding direction. For example, in the wave of output current, when a current flows in one direction for a first time, a +I (where I is an integer) value is output for the first time, and when a current flows in the other direction for a second time that is the same as or different from the first time, a -I value is output for the second time. For example, the wave of the output current may be output in a form such as a wave 510 shown in FIG. 6.

The sensor module 1400 may obtain data for the controller 1500 on the resonant frequency of the load or on the current or power supplied to the load. Referring back to FIG. 2, the sensor module 1400 may include a current transformer 1410, a filter 1420, and a comparator 1430. The sensor module 1400 may receive a current or voltage signal flowing through the load through the current transformer 1410, convert this signal into a current or voltage signal having a magnitude different therefrom, filter the converted current or voltage signal by using the filter 1420, and output a wave of an output current to the controller 1500 through the comparator 1430.

Here, the current transformer 1410 may be inductively coupled to distributing wires between the inverter 1300 and the load and may convert the voltage or current signal applied to the load and provide it to the filter 1420. Specifically, the current transformer 1410 may convert a current flowing in conducting wires connected to the load into a voltage signal.

Here, the filter 1420 may remove high frequency noise from an input current or voltage signal and output the noise-removed current or voltage signal to the comparator 1430. To this end, the filter 1420 may perform high pass filtering or low pass filtering.

Here, the comparator 1430 may obtain information about a wave of an output current. For example, the comparator 1430 may obtain information about the wave of the output current by comparing the voltage signal, which is obtained from the current transformer 1410 or the filter 1420, with a preset value. In this case, the information about the wave of the output current may mean phase data of a current applied to the load (i.e., a current output from the inverter 1300) or data about magnitudes and directions of the current.

At least one of components included in the above-described sensor module 1400 may be omitted.

Although not shown in FIG. 2, the RF generator 1000 may include a memory.

Here, the memory can store various data. Various data may be stored temporarily or semi-permanently in the memory. Examples of the memory may include a hard disk drive (HDD), a solid state drive (SSD), a flash memory, a read-only memory (ROM), a random access memory (RAM), etc. The memory may be provided in a form embedded in the RF generator 1000 or in a detachable form.

As described above, the RF generator 1000 may control a frequency of an alternating current provided to the load on the basis of data regarding the resonant frequency of the load. In other words, the RF generator 1000 may track the load's resonant frequency changing depending on changes in the state of plasma, control a frequency of an output alternating current so as to correspond to the resonant frequency of the load, and output an alternating current having the controlled frequency. In this way, unrequired power consumption may be prevented and the durability of the plasma system may be improved.

At least one component of the RF generator 1000 described above may be omitted. For example, the RF generator 1000 may obtain electrical data about the load from an external sensor without including the sensor module 1400. As another example, the RF generator 1000 may be provided with direct current or rectified direct current from an external source without including the AC power source 1100 and the rectifier 1200.

Hereinafter, a frequency control method according to the exemplary embodiment of the present specification is described. An RF generator 1000 may control a frequency of an alternating current applied to a load such as an antenna structure 2000 through the frequency control method. Specifically, the RF generator 1000 may detect a resonant frequency of the load including the antenna structure 2000, or may detect the electrical properties such as current, voltage, and the like over time, so as to periodically or aperiodically change or set a frequency of output (e.g., a frequency of an output AC voltage or a frequency of an output AC current) for generating or maintaining plasma.

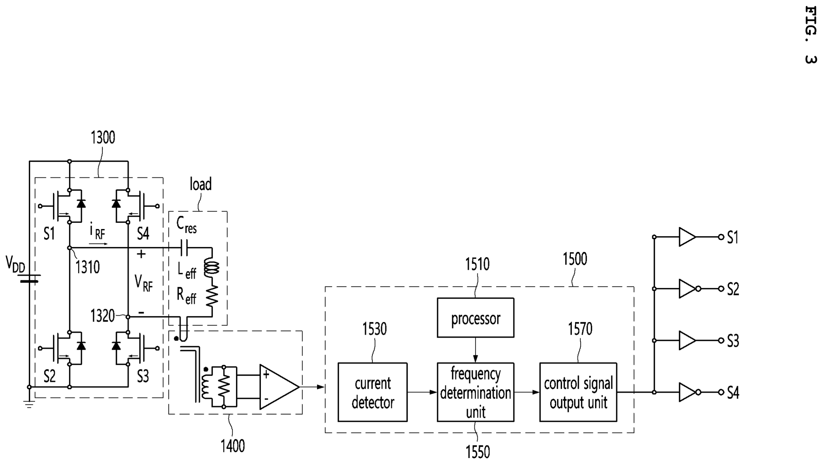

Hereinafter, a method of controlling a frequency of an alternating current applied to a load by a frequency control apparatus is described with reference to FIGS. 3 to 13.

FIG. 3 is a view illustrating a structure of an RF generator 1000 for frequency control according to the exemplary embodiment of the present specification.

Referring to FIG. 3, the RF generator 1000 may include an inverter 1300, a sensor module 1400, and a controller 1500 that includes a processor 1510, a current detector 1530, a frequency determination unit 1550, and a control signal output unit 1570. The RF generator 1000 may obtain information about a wave of output current of the inverter 1300, the output current being applied to a load, by using the sensor module 1400, and may transmit the information to the current detector 1530. In addition, the current detector 1530 may transmit the information about the wave of the received output current to the frequency determination unit 1550.

The inverter 1300 may receive direct current to change the direct current into alternating current and provide the alternating current to the load. To this end, the inverter 1300 may be provided as a half bridge type or a full bridge type. Hereinafter, for convenience of description, the inverter 1300 is described as being provided as the full bridge type, but the technical idea of the present specification is not limited thereto. In other words, the inverter 1300 may also be provided as the half-bridge type.

The inverter 1300 may include first to fourth switches S1, S2, S3, and S4.

Here, each of the first to fourth switches S1, S2, S3, and S4 may be turned on or off by receiving a control signal from the controller 1500. In this case, when the first and third switches S1 and S3 are turned on and the second and fourth switches S2 and S4 are turned off, a positive voltage may be applied to the load, and when the first and third switches S1 and S3 are turned off and the second and fourth switches S2 and S4 are turned on, a negative voltage may be applied to the load. In this way, the inverter 1300 may apply an AC voltage having a specific frequency to the load by alternately applying positive and negative voltages thereto. In the present specification, for convenience of description, when the voltage applied to the node 1610 and the node 1710 illustrated in FIG. 2 is higher than the voltage applied to the node 1630 and the node 1730 illustrated in FIG. 2, the voltage applied to the load is described as a "positive voltage", and when the voltage applied to the node 1610 and the node 1710 illustrated in FIG. 2 is lower than the voltage applied to the node 1630 and the node 1730 illustrated in FIG. 2, the voltage applied to the load is described as a "negative voltage". In addition, the node 1610 illustrated in FIG. 2 is a node 1310 located between the first switch S1 and the second switch S2 illustrated in FIG. 3, and the node 1630 illustrated in FIG. 2 is a node 1320 located between the third switch S3 and the fourth switch S4 illustrated in FIG. 3.

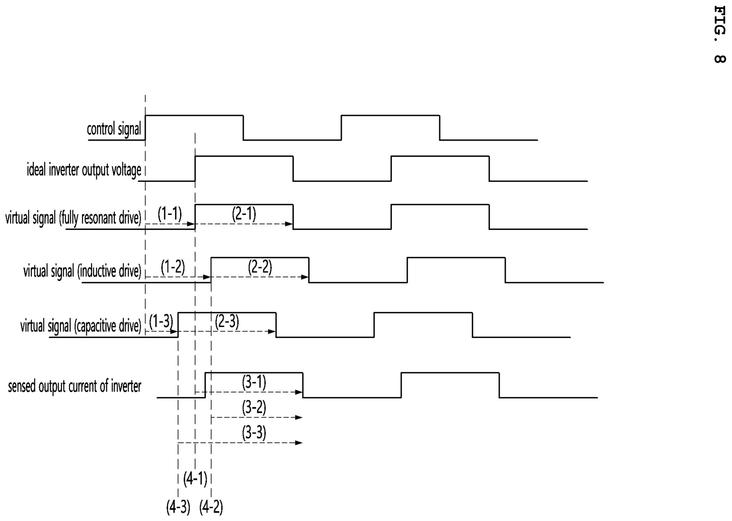

The sensor module 1400 may detect a phase (or a direction and/or a magnitude) of a current flowing to the load. As described in FIG. 2, the sensor module 1400 is electrically coupled to the load, so as to be able to obtain a current signal corresponding to the current flowing in the load and obtain information about a wave of an output current flowing in the load on the basis of the obtained current signal. Here, the wave of the output current is represented as a square wave by way of sensing phase and/or direction-related signals of the output current flowing to the load (refer to the sensed output current of the inverter illustrated in FIG. 8). Hereinafter, the phase and/or direction-related signals of the output current flowing to the load are referred to as the signals of the output current. In other words, a wave of an output current may include a plurality of signals of output current.

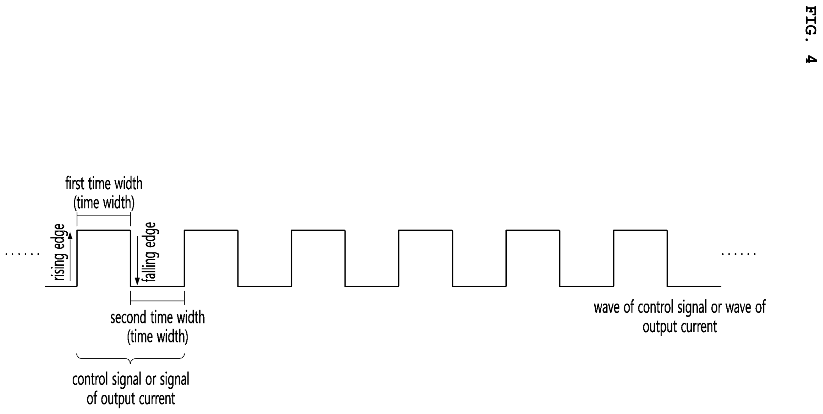

Specifically, this will be described with reference to FIG. 4. Here, a square waveform disclosed in FIG. 4 may be a waveform obtained by sensing the phase and/or direction-related signals of an output current flowing to a load. A wave of the output current may be defined as a set of a plurality of output current signals continuous in time. For example, a signal of an output current may include one rising edge and one falling edge, which are spaced apart by a first time width. In other words, the signal of the output current may refer to having a shape that increases in magnitude to +A along one rising edge, remains at +A for an interval equal to a first time width, decreases in magnitude to 0 or -B along a falling edge thereafter, and remains at 0 or -B again for an interval equal to a second time width. Here, A and B may have the same value or different values. In addition, the first time width and the second time width may be the same width or different widths.

The controller 1500 may output a wave of a first control signal corresponding to a first frequency to the inverter 1300 through the control signal output unit 1570.

The first control signal may be for appropriately turning on and/or off the four switches included in the inverter 1300 as described above so that a first AC voltage having a first frequency is applied to the load. In other words, the control signal output unit 1570 may generate and output a wave of a control signal corresponding to a frequency determined by the frequency determination unit 1550 so that an AC voltage having the frequency determined by the frequency determination unit 1550 is applied to the load. The first control signal may be expressed, for example, as the control signal illustrated in FIG. 8.

Here, a control signal wave mean a plurality of control signals is included therein. Similarly to the above description, referring to FIG. 4, the square waveform disclosed in FIG. 4 may be a representation of signals currently output to the inverter 1300 through the control signal output unit 1570. The control signal wave may be defined as a set of the plurality of control signals continuous in time. For example, a control signal may include one rising edge and one falling edge, which are spaced apart by a first time width. In other words, the control signal may refer to having a shape that increases in magnitude to +A along one rising edge, remains at +A for an interval equal to the first time width, decreases in magnitude to 0 or -B along a falling edge thereafter, and remains at 0 or -B again for an interval equal to a second time width. Here, A and B may have the same value or different values. In addition, the first time width and the second time width may be the same width or different widths.

In addition, in order to facilitate understanding in the description of the control signal, the same terms as A, B, a first time width, and a second time width are used as in the description of the output current signal, but it is apparent to those skilled in the art that A, B, the first time width, and the second time width in the control signal and A, B, the first time width, and the second time width in the output current signal are not necessarily the same values. In other words, A, B, the first time width, and the second time width are merely values arbitrarily set for convenience of description and should not be interpreted as limited to any specific value. A, B, the first time width, and the second time width for the output current signal and A, B, the first time width, and the second time width in the control signal may have values different from each other.

Meanwhile, in some exemplary embodiments disclosed by the present application, time points corresponding to a plurality of respective rising edges of control signals may mean: time points at which control signals for turning ON the first switch S1 and the third switch S3 and turning OFF the second switch S2 and the fourth switch S4 are output from the controller 1500; and time points corresponding to a plurality of respective falling edges of the control signals may mean time points at which control signals for turning OFF the first switch S1 and the third switch S3 and turning ON the second switch S2 and the fourth switch S4 are output from the controller 1500.

According to the above description, in the description described below, a first control signal wave may include a plurality of first control signals, and a second control signal wave may include a plurality of second control signals.

Meanwhile, the frequency determination unit 1550 may assume a virtual signal wave, which is a received first control signal wave shifted by a predetermined time. Here, the assuming of the virtual signal wave means that the corresponding virtual signal wave is not generated with physical or electrical signals, nor is output to another device or module. That is, the frequency determination unit 1550 may use the virtual signal wave in calculating a delay time or a phase difference with respect to an output current wave by implementing a virtual signal wave in software or virtually assuming a virtual signal wave without generating the virtual signal wave with physical or electrical signals.

Here, the calculation of phase difference or delay time may mean that a phase difference or a delay time is detected/sensed. Hereinafter, it should be noted in advance that in the description of the present specification as well, the calculation of phase difference or delay time may be interpreted as detecting/sensing a phase difference or a delay time.

However, the exemplary embodiment implemented according to the present disclosure is not necessarily limited thereto. For example, as described above, a virtual signal wave may be implemented in software or assumed virtually, but may also be signals that are actually output as physical or electrical signals. For example, the frequency determination unit 1550 may physically or electrically generate a virtual signal wave by shifting a control signal wave output from the control signal output unit 1570 by a predetermined time according to a circuit configured within the frequency determination unit 1550, thereby calculating a delay time or a phase difference between the output current wave and the virtual signal wave generated physically or electrically.

Meanwhile, since the virtual signal wave is the first control signal wave shifted, the plurality of first control signals included in the first control signal wave may respectively correspond to the plurality of virtual signals included in the virtual signal wave. That is, the plurality of virtual signals included in the virtual signal wave may respectively correspond to the plurality of first control signals in that order.

For example, the shifting of the first control signal wave to generate the virtual signal wave includes: determining time points corresponding to rising edges of a virtual signal wave by adding or subtracting a value corresponding to a predetermined time to or from each of time points corresponding to rising edges of first control signals; determining time points corresponding to falling edges of the virtual signal wave by adding or subtracting the value corresponding to the predetermined time to or from each of time points corresponding to falling edges of the first control signals; and then generating a square wave corresponding to the time points of the determined rising edges and the time points of the determined falling edges.

Here, the predetermined time may be determined on the basis of a time difference between the time points at which the rising edges or falling edges of the first control signals are output from the controller 1500 to the inverter 1300 and the time points at which AC voltages generated by the operation of the first to fourth switches S1, S2, S3, and S4 controlled by the first control signal wave are expected to be output from the inverter 1300. That is, the predetermined time may be determined to be the same value as the time difference described above, but may also be determined to be a value longer or shorter than the corresponding time difference. For example, determining the predetermined time to be the same value as the time difference may be called a fully resonant drive, determining the predetermined time to be a value longer than the time difference may be called an inductive drive, and determining the predetermined time to be a value shorter than the time difference may be called a capacitive drive.

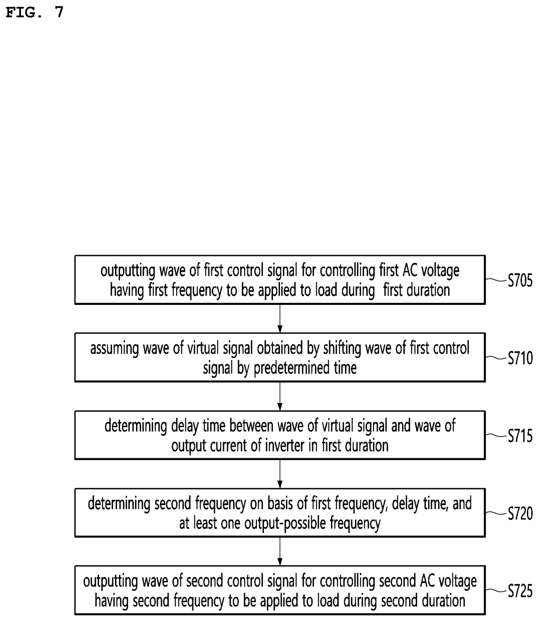

A detailed description of these fully resonant drive, inductive drive, and capacitive drive will be given below on the basis of FIGS. 7 and 8.

Hereinafter, for convenience of description, the time difference between a wave of a first control signal and a wave of an (expected ideal) output voltage means actual (or expected) time differences between the time points of the rising edges and falling edges of the first control signals as described above and the time points of the ideal rising edges and ideal falling edges of the AC voltages actually output through the inverter.

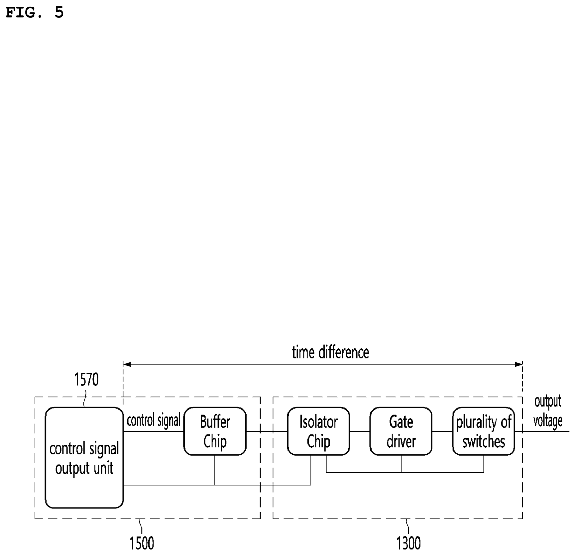

FIG. 5 is a view illustrating a time difference between a wave of a first control signal and a wave of an output voltage. However, the components shown in FIG. 5 (e.g., a control signal output unit 1570, a buffer, an isolator, a gate driver, and/or a plurality of switches) merely illustrate an exemplary embodiment of components constituting a controller 1500 and an inverter 1300, and are not limited thereto. In other words, at least one of the components shown in FIG. 5 may not be included, and an additional component may also be included therein. In addition, each component shown in FIG. 5 may be configured as an individual chip or individual circuit, or two or more components may be configured as one chip or circuit.

Referring to FIG. 5, when the wave of the first control signal is output from the controller 1500 and applied to the plurality of switches of the inverter 1300, a DC voltage applied to the inverter 1300 according to the wave of the first control signal is output as an AC voltage through the buffer, the gate driver, and the plurality of switches, which are described above. At this time, it takes a certain amount of time for the AC voltage to be output through the buffer, the gate driver, and the plurality of switches, which are described above. A predetermined time it takes as such is a time difference between a time at which the wave of the first control signal is input from the controller 1500 to the inverter 1300 and a time at which the AC voltage generated by the wave of the first control signal is expected to be output from the inverter 1300. By utilizing such a time difference, the wave of the first control signal is shifted, whereby a wave of a virtual signal may be assumed. In other words, the wave of the virtual signal may have a waveform of an ideal output voltage expected when it is assumed that an output voltage from the inverter 1300 is output without any noise.

In this case, as described below, the wave of the virtual signal is used to calculate a delay time and/or a phase difference with respect to a wave of an output current. In light of the above description, ultimately, the frequency determination unit 1550 assumes the wave of the virtual signal in order to calculate the delay time and/or phase difference between the wave of the output current of the inverter 1300 and the wave of the output voltage of the inverter 1300.

Meanwhile, the reason why a wave of an output voltage is not directly sensed to directly calculate a delay time and/or phase difference with respect to a wave of an output current in the exemplary embodiment of the present specification is as follows.

Referring to FIG. 6, a waveform of a load's output current indicated by $i_{RF}$ is obtained as a form of a pure sine wave (or a cosine wave) in most cases. Accordingly, through the sensor module 1400, a wave for measuring phases of the output current (i.e., a wave of the output current) may be obtained relatively easily in a form such as a wave 510.

However, in a case of the load's output voltage indicated by $V_{RF}$, it is very difficult to accurately and reliably obtain a wave for phase measurement of the output voltage due to high frequency resonance noise generated by the switching of the plurality of switches included in the inverter 1300. Accordingly, it is quite difficult to sense/detect a phase difference or a delay time between the output voltage of the load and the output current of the load relatively accurately by way of directly sensing and comparing the output voltage of the load with the output current of the load.

In addition, when the phase difference or delay time between the output voltage of the load and the output current of the load may not be accurately sensed/detected, there may be considerable difficulty in controlling a frequency of an AC voltage applied to the load by tracking a resonant frequency of the variable load.

Accordingly, the present specification intends to assume a wave of a virtual signal obtained by shifting a wave of a control signal that controls the operation of the switches of the inverter 1300 through the controller 1500 by a predetermined time on the basis of the time difference described in FIG. 5, so as to calculate a phase difference or a delay time between the wave of the virtual signal and the wave of the load's output current sensed by the sensor module 1400, thereby performing frequency tracking.

The reason why the wave of the virtual signal obtained by shifting the wave of the control signal is able to be used instead of using the output voltage of the load is that the wave of the output voltage of the load is different from the wave of the control signal only in magnitude and output patterns (or phases) thereof are the same to each other in the case of assuming that the output voltage of the load is output in an ideal form without noise. In other words, this is because it is possible to easily predict the wave of the load output voltage that will be output in a form delayed by the time difference described in FIG. 5, while only the magnitude of the wave of the control signal is changed depending on a magnitude of a DC voltage applied to the inverter 1300 and while a length or a pattern (or a phase) of the control signal included in the wave of the control signal remains the same.

Accordingly, since the wave of the virtual signal, which is shifted by the time difference described in FIG. 5 from the wave of the control signal, is different only in magnitude from the wave of the output voltage of the ideal load and is the same in pattern (or phase), there is no problem in comparing the phase difference or delay time between the output current of the load and the output voltage of the load.

Meanwhile, the time difference in FIG. 5 may be measured experimentally or inferred through the specifications of the components included in the inverter 1300, but is not limited thereto, and the time difference may be determined in various ways. In addition, the time difference in FIG. 5 may be preset and may be constant when there is no change in the inverter 1300 itself or the structure of the inverter 1300.

During at least some duration within a first duration, the frequency determination unit 1550) may use a clock of the processor 1510 to detect/sense a delay time between a wave of a virtual signal (i.e., a wave of an ideal output voltage) and a wave of an output current of the inverter 1300 in the first duration. Here, a detailed method of detecting/sensing the delay time will be described in detail below with reference to FIG. 7.

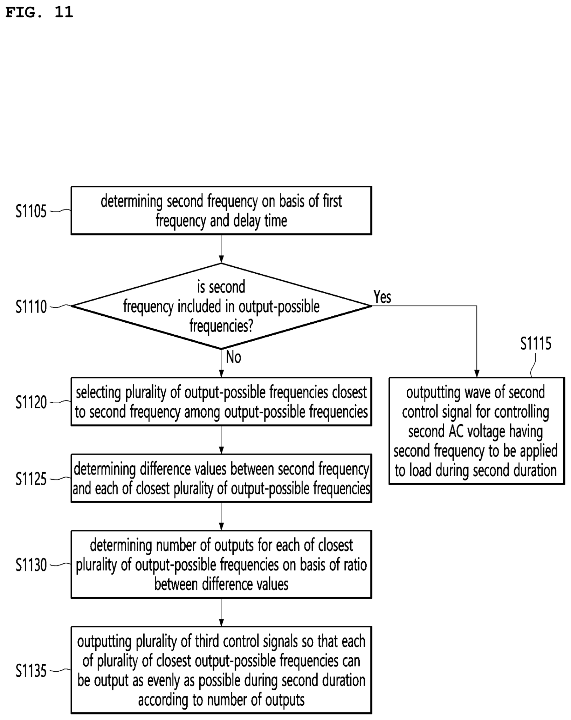

In addition, the frequency determination unit 1550 may determine a second frequency of a second AC voltage applied to the load during a second duration immediately after the first duration on the basis of at least one output-possible frequency that may be determined according to properties including: a first frequency of a first AC voltage to be generated by a wave of a first control signal; a detected/sensed delay time; and a clock of the processor 1510. Here, a detailed method of determining a second frequency will be described in detail below with reference to FIGS. 7 and 11.

Here, the first duration may mean the duration corresponding to a present time when the RF generator 1000 operates according to the first frequency. In addition, the second duration is a time duration immediately after the first duration ends, and may mean the duration corresponding to the next time when the RF generator 1000 operates according to the second frequency after the first duration ends. Meanwhile, there may also be a third duration, which is a time duration immediately after the second duration ends. The third duration may mean duration corresponding to a time during which the RF generator 1000 applies an AC voltage having a third frequency to the inverter 1300 according to the exemplary embodiment described in the present disclosure after the second duration ends. Here, the third frequency is a frequency determined for the third duration according to the exemplary embodiment of the present disclosure on the basis of the second frequency. For example, the exemplary embodiment of the present disclosure may be equally applied to determine the third frequency of the third duration. For example, since a method of determining a third frequency from a second frequency is the same as the method of determining the second frequency from a first frequency, determining the third frequency in the exemplary embodiment of the present disclosure may be construed and applied by way of respectively replacing the "first frequency" and a "first AC voltage" with the "second frequency" and a "second AC voltage" and respectively replacing the "second frequency" and the "second AC voltage" with the "third frequency" and a "third AC voltage".

In addition, for convenience of description, it is assumed that the first frequency of the first AC voltage output in the first duration is any one of at least one output-possible frequency that may be determined by using the clock of the processor 1510, but is not limited thereto.

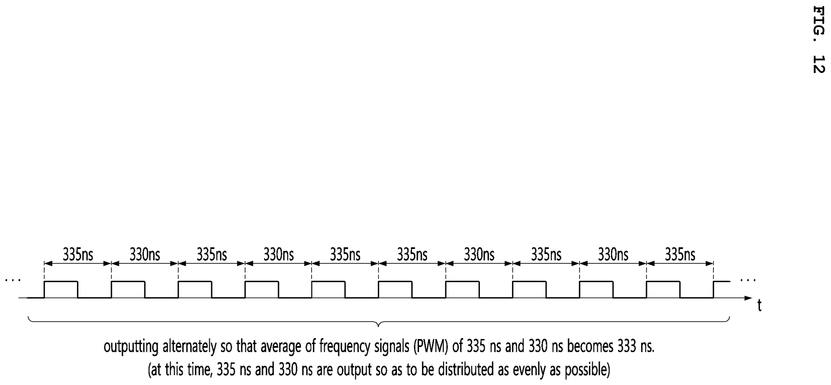

For example, the first frequency may also not be included in the at least one output-possible frequency. In such a case, the first frequency may also be output by utilizing a plurality of output-possible frequencies as described in FIG. 12. A method of generating a first frequency or second frequency by using the plurality of output-possible frequencies is described in detail in FIG. 12.

Even in such a case, the method of determining the second frequency output in the second duration may be applied in the same manner as the exemplary embodiment disclosed in the present specification, so that the second frequency may be determined, which will be apparent to those skilled in the art.

The control signal output unit 1570 may output a wave of a second control signal that controls the switches of the inverter 1300 so that a second AC voltage having a determined second frequency may be applied to the load during a second duration. In addition, when the wave of the second control signal is input to the inverter 1300, the switches of the inverter 1300 are turned on and/or off, thereby generating the second AC voltage having the second frequency, which may be applied to the load.

Now, referring to FIG. 7, methods for frequency control according to the exemplary embodiment of the present specification will be described. Meanwhile, the frequency control method described on the basis of FIG. 7 may be performed by control of the controller 1500. That is, unless otherwise specified, the following descriptions may be controlled or performed by the controller 1500 of the RF generator 1000.

Meanwhile, the components including the processor 1510, current detector 1530, frequency determination unit 1550, and control signal output unit 1570, which are included in the controller 1500 described in FIG. 3, is distinguished according to a function performed by each component for convenience of description, and is not limited to hardware components. That is, each component included in the controller 1500 may be implemented in the form of software or program code, or may also be implemented in the form of a circuit using various elements. Accordingly, each component included in the controller 1500 may not be physically distinguished. In other words, each component included in the controller 1500 may be functionally distinguished from each other.

Therefore, each process or each step described in FIG. 7 below should be understood as being controlled or performed by the controller 1500 unless otherwise specifically described, and should not necessarily be understood as being performed by each specific, separate, and distinct component within the controller 1500. In addition, even when described without special distinction, those skilled in the art will be able to easily understand, through the description related to FIG. 3, which components of the controller 1500 control and perform respective processes or steps described in FIG. 7.

Referring to FIG. 7, a controller 1500 may perform step S705 of outputting a wave of a first control signal to an inverter 1300 so that a first AC voltage having a first frequency is applied to a load during a first duration. In addition, the controller 1500 may perform step S710 of assuming a wave of a virtual signal obtained by shifting the wave of the first control signal by a predetermined time. In this case, the predetermined time as described above is determined on the basis of a time difference as described in FIG. 5, but is not necessarily the same as the corresponding time difference.

Referring to FIG. 8, the controller 1500 may assume that a wave of a virtual signal is obtained by shifting a wave of a first control signal by a corresponding time difference so as to have the same phase as that of a wave of an output voltage of an ideal inverter 1300, the wave of the output voltage being expected to be output according to the corresponding time difference, and this may be called a fully resonant driving mode. For example, referring to FIG. 8, in the fully resonant driving mode, a predetermined time may be equal to a corresponding time difference, such as duration of (1-1).

In addition, it may be assumed that the controller 1500 shifts the wave of the first control signal by a greater amount than the corresponding time difference, so that the wave of the virtual signal follows (i.e., lagging) a wave of an output voltage of the ideal inverter 1300, the output voltage being expected to be output according to the corresponding time difference, and this may be called an inductive driving mode. For example, referring to FIG. 8, in the inductive driving mode, the predetermined time may be longer than the corresponding time difference, such as duration of (1-2).

In addition, it may be assumed that the controller 1500 shifts the wave of the first control signal by a lesser amount than the corresponding time difference, so that the wave of the virtual signal leads (i.e., leading) the wave of the output voltage of the ideal inverter 1300, the output voltage being expected to be output according to the corresponding time difference, and this may be called a capacitive driving mode. For example, referring to FIG. 8, in the capacitive driving mode, the predetermined time may be shorter than the corresponding time difference, such as duration of (1-3).

The fully resonant driving mode may be used when a voltage generated by passive elements (e.g., an inductor and a capacitor) included in a load is to be offset as precisely as possible, thereby reducing a voltage of the inductor (e.g., a coil) included in the load. For example, when the load is a plasma generator for plasma generation, it may be suitable to offset an LC voltage of a plasma source as precisely as possible to lower a voltage of an antenna of the plasma generator and maintain plasma discharge at a maximum power factor state.

The inductive driving mode may be suitable when a plurality of switches included in the inverter 1300 performs soft switching and maintain a specific load state (e.g., plasma discharge).

The capacitive driving mode may be suitable when it is desired to stably maintain a specific state (e.g., plasma discharge) of a gas (e.g., NF3) that is sensitive to surroundings such as flow rate, power, and pressure.

In other words, by selecting which of the above-described three driving modes to operate in, depending on the specific state of the load (e.g., a plasma discharge state), the controller 1500 may shift the wave of the first control signal by a predetermined time according to the selected driving mode. That is, by determining the predetermined time to be longer, shorter, or equal to the time difference described in FIG. 5, an operation suitable for the specific state of the load (e.g., an operation suitable for maintaining plasma discharge) may be allowed to be performed.

In a case when the RF generator 1000 operates in the capacitive driving mode or inductive driving mode, it is required to determine how much larger or smaller first control signal is to be shifted than the time difference described in FIG. 5. This may be fundamentally determined depending on the specific state of the load (e.g., the plasma discharge state), but may preferably be selected within a range of 10 ns or more and 40 ns or less. For example, when the RF generator 1000 operates in the capacitive driving mode, the controller 1500 may assume a wave of a virtual signal obtained by shifting a wave of a first control signal by a time shorter than the time difference described in FIG. 5, i.e., 10 ns or more and 40 ns or less.

For example, when the RF generator 1000 operates in the inductive driving mode, the controller 1500 may assume a wave of a virtual signal obtained by shifting a wave of a first control signal by a time longer than the time difference described in FIG. 5, i.e., 10 ns or more and 15 ns or less.

Meanwhile, selecting which driving mode to shift a wave of a first control signal may be performed by a user who is monitoring a specific state of the load (e.g., a plasma discharge state) and then inputting or setting a driving mode or a predetermined time to be used for shifting. Alternatively, the controller 1500 may periodically or aperiodically monitor the specific state of the load (e.g., the plasma discharge state) to adaptively determine by itself a predetermined time for shifting a wave of a first control signal or may determine and apply a driving mode.

Meanwhile, among the three driving modes described above, the capacitive driving mode is generally the most widely used. This is because operating in the capacitive driving mode is effective in maintaining the specific state of the load (e.g., the plasma discharge).

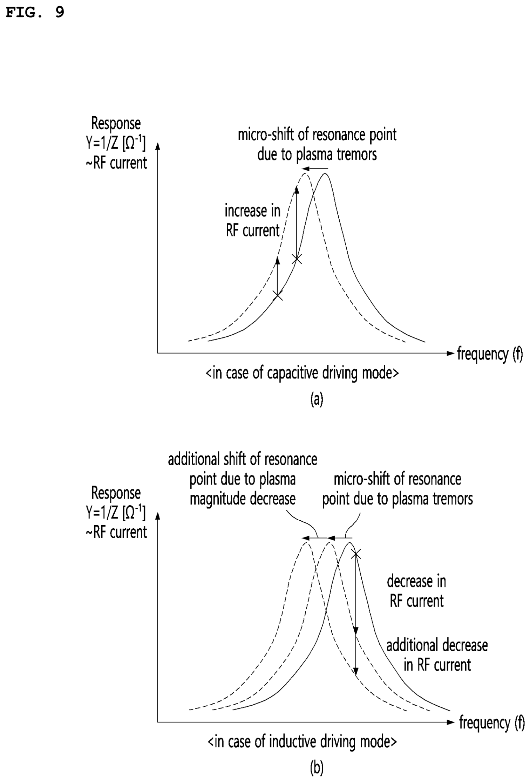

This will be described through FIG. 9. FIG. 9(a) shows a change in a resonant frequency in a case of operation in the capacitive driving mode, and FIG. 9(b) shows a change in a resonant frequency in a case of operation in the inductive driving mode.

For example, in a case where inductive coupling between an antenna for plasma discharge and particular plasma is weakened during the plasma discharge, effective inductance may increase as a resonant frequency of the antenna may decrease.

In such a case, when a frequency tracking operation is performed according to the capacitive driving mode, as may be seen in FIG. 9(a), a magnitude of current flowing from the RF generator 1000 to the antenna (i.e., the load) increases as the resonant frequency of the antenna decreases. When this occurs, power applied to the plasma is increased, and the resonant frequency of the antenna may be increased again as the inductive coupling between the antenna and the plasma is strengthened. Accordingly, the resonant frequency of the antenna may be restored to its original state, and stable negative feedback may be realized. That is, when the operation is performed in the capacitive driving mode, the stable negative feedback is realized when the resonant frequency of the antenna is varied, whereby there may be an effect of stably maintaining plasma discharge, and the stable frequency tracking operation may also be enabled.

Meanwhile, when a frequency tracking operation is performed according to the inductive driving mode, as may be seen in FIG. 9(b), a magnitude of current flowing from the RF generator 1000 to the antenna (i.e., the load) is lowered as a resonant frequency of the antenna is lowered. Accordingly, as the power applied to the plasma decreases and the inductive coupling between the antenna and the plasma weakens, the resonant frequency of the antenna becomes lower. When this occurs, the power applied to the plasma is further reduced, resulting in an unstable positive feedback in which the resonant frequency of the antenna is further lowered, whereby the effect of stably maintaining the plasma discharge is unable to be obtained.

For the reasons described above, it is generally preferred to implement the frequency tracking operation in the capacitive driving mode rather than the inductive driving mode.

However, the capacitive driving mode is not preferred over the inductive driving mode in all cases, and the inductive driving mode may also be preferred depending on the state of plasma and the field to which frequency tracking is applied.

[Table 1] compares discharge stabilization effects of NF3 gas between a case when a frequency tracking operation is implemented through the capacitive driving mode and a case when a frequency tracking operation is implemented through the inductive driving mode.

[Table 1]

| Number | Frequency tracking speed (FTR0105 frq_change_cycle) | Predetermined time and driving mode used for shifting wave of first control signal (FTR0108 phase_shift_lock) | Plasma discharge maintenance success rate |
|---|---|---|---|
| 1 | 5 μs/each | 90 ns (Capacitive) | 50% (5/10) |
| 2 | 50 μs/each | 90 ns (Capacitive) | 95% (16/17) |
| 3 | 200 μs/each | 90 ns (Capacitive) | 80% (8/10) |
| 4 | 5 μs/each | 120 ns (Inductive) | 10% (1/10) |
| 5 | 50 μs/each | 120 ns (Inductive) | 0% (0/10) |
| 6 | 200 μs/each | 120 ns (Inductive) | 0% (0/10) |

[Table 1] shows that implementing the frequency tracking operation in the capacitive mode is much more effective in terms of plasma discharge effects.

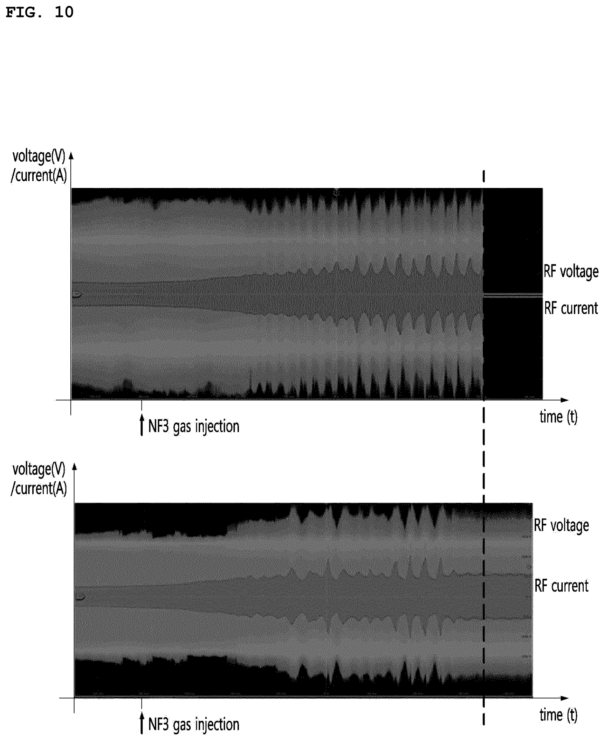

Meanwhile, FIG. 10 shows outputting experimental data on a discharge effect in a case where NF3 gas is injected during argon (Ar) plasma discharge according to some cases in [Table 1]. In both FIG. 10(a) and FIG. 10(b), the NF3 gas is injected after approximately 20 ms from a time point of starting the argon (Ar) plasma discharge. FIG. 10(a) shows NF3 injection according to Case number 4 (i.e., the inductive mode) of [Table 1]. According to FIG. 10(a), an interlock occurs after a time point indicated by a dotted line due to a continuously increased current, resulting in voltage and current that do not flow and the discharge effect that disappears. In contrast, FIG. 10(b) shows that NF3 is injected according to Case number 1 (i.e., the capacitive mode) of [Table 1], and shows that the discharge effect is stably maintained. Referring to FIG. 10, it may be seen that the discharge effect is stably maintained in the capacitive driving mode.

Meanwhile, when assuming that a wave of a virtual signal shifted by a predetermined time on the basis of the selected driving mode according to step S710, the controller 1500 may determine a delay time between the wave of the corresponding virtual signal and a wave of an output current of the inverter 1300 sensed in a first duration in step S715. Here, determining a phase difference or a delay time may mean that the phase difference or delay time is detected/sensed. Hereinafter, it should be noted in advance that in the description of the present specification as well, the determining of the phase difference or delay time may be interpreted as detecting/sensing the phase difference or delay time.

For example, referring to FIG. 8, as described above, the controller 1500 may assume a wave of a virtual signal obtained by shifting a control signal by a predetermined time of any one of (1-1), (1-2), or (1-3) depending on a selected driving mode. In addition, as in a time length (2-1), (2-2), or (2-3), the controller 1500 may obtain a first counting value by counting a first time length from a rising edge (i.e., (4-1), (4-2), or (4-3)) of the wave of the virtual signal to a first falling edge appearing after the rising edge according to a clock of the processor 1510.

For example, in a case where a clock frequency of the processor 1510 is 200 MHz, a minimum time unit that may be counted with the corresponding clock is 1 / (200 * 10^6) = 5 ns. Accordingly, when a first time length is 100 ns, a first counting value according to the first time length is 20. Similarly, when a first time length is 105 ns, a first counting value according to the first time length is 21.

Meanwhile, in a case where a first time length is not an integer multiple of a minimum time unit, a first counting value may be determined on the basis of a period of each pulse wave generated according to a clock. For example, when counting on the basis of the end point of a period of each pulse wave is performed, a first counting value according to a first time length may be 20 in a case when the first time length is 103 ns, and a first counting value according to a first time length may be 19 in a case when the first time length is 97 ns. This may be the obtaining of the same result as applying a floor function to a value of the first time length divided by the minimum time unit.

When counting is performed on the basis of the starting point of the period of each pulse wave generated, a counting value according to a first time length may be 21 in a case when the first time length is 103 ns, and a counting value according to a first time length may be 20 in a case when the first time length is 97 ns. This may be the obtaining of the same result as applying a ceil function to a value of the first time length divided by the minimum time unit.

For convenience of description, the following description of the present specification will be based on counting from the end point of the period of each pulse wave. However, this is not limited thereto. That is, since it is apparent to those skilled in the art that the exemplary embodiments of the present specification are applied by counting on the basis of the starting point of the period of each pulse wave in the description of the present specification, it is apparent that the implementation of the exemplary embodiments described in the present specification may be easily replaced with examples in which the counting is performed on the basis of the starting point of the period of pulse waves.

Referring back to FIG. 8, as in (3-1), (3-2), or (3-3), the controller 1500 may count a second time length from a rising edge (i.e., (4-1), (4-2), or (4-3)) of a wave of a virtual signal to a falling edge of a wave of an output current of the inverter 1300, the falling edge appearing firstly after the relevant rising edge according to a clock of the processor 1510, as described above. In other words, the controller 1500 may obtain a second counting value for the second time length by using the minimum time unit according to the clock of the processor 1510.

Meanwhile, in obtaining the first counting value and the second counting value, when the first time length serving as a reference is determined as a length from a rising edge of a wave of a control signal to a falling edge of a wave of a virtual signal, or the second time length is determined as a length from a rising edge of the wave of the virtual signal to a rising edge of a wave of a next output current being occurred after the corresponding rising edge or from the rising edge of the wave of the control signal to a falling edge of the wave of the output current being occurred after the corresponding rising edge, the following problems may occur.

First, in a case where a second time length is determined as a length from a rising edge of a wave of a virtual signal to a rising edge of a wave of a next output current being occurred after the relevant rising edge, the rising edge of the wave of the output current may occur in time earlier than the rising edge of the wave of the virtual signal corresponding to the relevant rising edge when the inverter 1300 operates in a capacitive region. However, in this case, when counting starts at the rising edge of the wave of the virtual signal, the controller 1500 detects the next rising edge of the wave of the output current rather than the rising edge of the wave of the output current corresponding to the relevant rising edge, whereby it may be incorrectly detected as if the inverter 1300 operates in the inductive region although in reality the inverter 1300 operates in a capacitive region.

Meanwhile, in the case where a first time length is determined as a length from a rising edge of a wave of a control signal to a falling edge of a wave of a virtual signal, or in a case where a second time length is determined as a length from the rising edge of the wave of the control signal to a falling edge of a wave of a next output current being occurred after the relevant rising edge, the wave of the output current is delayed in time compared to the wave of the virtual signal when the inverter 1300 operates in an inductive region. At this time, when the degree of delay is considerably large and the falling edge of the wave of the output current occurs later in time than a second falling edge of the wave of the virtual signal, it may be incorrectly detected as if the inverter 1300 operates in a capacitive region although in reality the inverter 1300 operates in the inductive region.

Meanwhile, in a case where a first time length is set as a length from a rising edge (or a falling edge) of a wave of a virtual signal to the next rising edge (or the next falling edge) being occurred after the relevant rising edge (or the relevant falling edge), and a second time length is set as a length from the rising edge (or a falling edge) of the wave of the virtual signal to a rising edge (or a falling edge) of a wave of an output current being firstly occurred after the relevant rising edge (or the relevant falling edge), a delay time may be incorrectly detected depending on the degree of a phase difference or delay between a wave of an ideal output voltage and the wave of the output current described above and the degree to which the virtual signal is shifted compared to the wave of the ideal output voltage.

For example, as shown in FIG. 8, in a case where a wave of an ideal output voltage is ahead of a wave of an output current in phase, a first time length is set as a length from a rising edge of a wave of a virtual signal to the next rising edge appearing after the relevant rising edge, and a second time length is set as a length from the rising edge of the wave of the virtual signal to a rising edge of the wave of the output current being firstly occurred after the relevant rising edge, a delay time may be incorrectly detected in at least one of capacitive driving, fully resonant driving, and inductive driving, depending on the degree of delay between the wave of the ideal output voltage and the wave of the output current. For example, when describing the fully resonant driving of FIG. 8 as an example, a second counting value is calculated by setting, as a second time length, a length from a time point (4-1) to a rising edge of the wave of the output current being firstly occurred after (4-1). However, in order for the delay time to be calculated properly, the rising edge of the wave of the firstly occurred output current should correspond to the end point of the first time length. However, in the example described above, the rising edge of the wave of the output current that is actually occurred for the first time is the rising edge corresponding to the starting point of the first time length (i.e., the rising edge corresponding to (4-1)), so an error may occur in the detection of the delay time.

Likewise, even in a case where a first time length is set as a length from a falling edge of a wave of a virtual signal to the next falling edge appearing after the relevant falling edge and where a second time length is set as a length from the falling edge of the wave of the virtual signal to a falling edge of a wave of an output current being firstly occurred after the relevant falling edge, when a wave of an ideal output voltage lags behind the wave of the output current, the falling edge at the end point of the second time length may correspond to the falling edge corresponding to the starting point of the first time length depending on the degree of lagging, thereby causing errors in delay time detection. For the same reason as described above, as in the time length (2-1), (2-2), or (2-3), it may be preferable that the controller 1500 obtains a first counting value by counting the first time length from the rising edge of the wave of the virtual signal (i.e., (4-1), (4-2), or (4-3)) to the first falling edge being firstly occurred after the relevant rising edge according to the clock of the processor 1510.

Likewise, as in the time length (3-1), (3-2), or (3-3), it is preferable that the controller 1500 obtains a second counting value by counting a second time length from the rising edge (i.e., (4-1), (4-2), or (4-3)) of the wave of the virtual signal to the falling edge of the wave of the output current of the inverter 1300, the falling edge being firstly occurred after the relevant rising edge according to the clock of the processor 1510, as described above.

When the controller 1500 obtains the first counting value and the second counting value, the controller 1500 may perform step S715 of calculating a difference value between the first counting value and the second counting value, and determining a delay time between the wave of the virtual signal and the wave of the output current of the inverter 1300 output in the first duration. For example, the controller 1500 may determine a value obtained by subtracting the second counting value from the first counting value as the delay time between the wave of the virtual signal and the wave of the output current of the inverter 1300. In this case, as described above, the determined delay time cannot be said to be the delay time between actual voltage and current, because the delay time is detected/sensed between the sensed output current and the virtual signal shifted by a predetermined time according to the control signal and each mode. However, as already described, the objective of the present specification is to utilize various beneficial effects arising from using a virtual signal instead of measuring the phases of voltage, so a delay time between voltage and current should be understood as a delay time between the virtual signal and the current, not a delay time between the voltage and current, which actually exist even without any special limitation or description of the delay time between the virtual signal and the current.

In addition, the controller 1500 may perform step S720 of determining a second frequency, which is a frequency of an AC voltage output from the inverter 1300 in a second duration immediately after the first duration on the basis of the delay time.

For example, when a corresponding delay time is within a preset range, the controller 1500 may output a wave of a second control signal identical to a wave of a first control signal to the inverter 1300 so that the inverter 1300 outputs an AC voltage having the same frequency as a first frequency in a second duration immediately after a first duration (i.e., so that an AC voltage is applied to the load). In other words, when the corresponding delay time is within the preset range (e.g., greater than or equal to a first value and less than or equal to a second value), the controller 1500 may maintain a frequency of the AC voltage without changing the frequency even in the second duration immediately after the first duration.

Meanwhile, when the corresponding delay time is out of the preset range (e.g., greater than or equal to the first value and less than or equal to the second value), the controller may output a wave of a second control signal different from the wave of the first control signal to the inverter 1300 so that the inverter 1300 outputs an AC voltage having a frequency different from the first frequency in the second duration (i.e., so that an AC voltage is applied to the load). For example, in a case where the delay time is less than the first value, the controller 1500 may determine a second frequency lower than the first frequency and output the wave of the second control signal to the inverter 1300 so that the inverter 1300 outputs an AC voltage having the second frequency in the second duration (i.e., applies an AC voltage to the load). In addition, in a case where the delay time is greater than the second value, the controller 1500 may determine a second frequency greater than the first frequency and output the wave of the second control signal to the inverter 1300 so that the inverter 1300 outputs an AC voltage having the second frequency in the second duration (i.e., applies an AC voltage to the load).

Meanwhile, the first value and the second value may be determined according to a tolerance range. In a case when a first value is -1 and a second value is +1, the tolerance range of an actual delay time may be from -10 ns to +10 ns. In a case when both the first and second values are 0, a tolerance range of an actual delay time may be from - 5 ns to +5 ns.

Meanwhile, an example of a tolerance range of an actual delay time according to first and second values may be as in [Table 2].

[Table 2]

| Preset range | | Tolerance range of actual delay time (ns) | |
| --- | --- | --- | --- |
| First value | Second value | Error range according to first value | Error range according to second value |
| 0 | 0 | -5 | +5 |
| -1 | 1 | -10 | +10 |
| -2 | 2 | -15 | +15 |

Meanwhile, the first value and the second value may be different from or the same to each other, and absolute values of the first value and the second value do not necessarily have to be the same. For example, when a tolerance range of an actual delay time is -5 ns to +10 ns, a first value may be 0 and a second value may be 1, and when a tolerance range of an actual delay time is -10 ns to +15 ns, a first value may be -1 and a second value may be 2.

Meanwhile, depending on the tolerance range of the actual delay time and the result values of the derived delay time, the first value and the second value may be set to rational numbers rather than integers. That is, the first and second values do not necessarily have to be integers, and may be rational numbers that include decimal points.

The above description shows that the controller 1500 calculates one delay time by using one first counting value and one second counting value, and determines a second frequency by using the calculated one delay time. However, the controller 1500 may calculate one delay time by using a plurality of first counting values and a plurality of second counting values, and determine a second frequency by using the calculated one delay time. In such a case, the controller 1500 may calculate delay times by using difference values between the plurality of respective first counting values and the plurality of respective second counting values, and determine a second frequency by using an average value of the corresponding delay times.

In this case, a first value and a second value do not necessarily have to be integers, but may be rational numbers having decimal points, which may be determined according to a tolerance range of an actual delay time.

Meanwhile, it is mentioned in the above-described section that the controller 1500 may determine the second frequency by using the plurality of first counting values and the plurality of second counting values. An example therefor is described below.

The first and second durations described above are the continuous durations in time, and the second duration may be present immediately after the first duration. In addition, the first and second durations are periods in which the controller 1500 determines whether to change a frequency of an AC voltage currently being output. That is, when outputting a wave of a first control signal for outputting a first AC voltage having a first frequency from a starting point of a first duration, the controller 1500 may output a wave of a second control signal for outputting a second AC voltage having a second frequency from a starting point of a second duration.

In this case, the lengths of the first duration and the second duration may be the same to or different from each other.

For example, in a first duration, a first control signal wave including a plurality of first control signals and an output current wave including a plurality of output current signals may be output. Accordingly, the controller 1500 may assume a virtual signal wave obtained by shifting a first control signal wave by a predetermined time in the first duration, and the corresponding virtual signal wave may include a plurality of virtual signals. Here, as described in FIG. 4, since the virtual signal wave is obtained by shifting the control signal wave, each virtual signal may refer to having a shape as each control signal that increases in magnitude to +A along one rising edge, remains at +A for an interval equal to a first time width, decreases in magnitude to 0 or -B along a falling edge thereafter, and remains at 0 or -B again for an interval equal to a second time width. Here, A and B may have the same value or different values. In addition, the first time width and the second time width may be the same width or different widths. For example, in a case when the first time width and the second time width are the same to each other and a frequency of the control signal wave is 2 MHz, a frequency of the virtual signal wave will also be 2 MHz, so the sum of the first time width and the second time width may be 0.5 us. In addition, each of the virtual signals included in the virtual signal wave may have the same first time width and second time width, but may also have the first time width and the second time width different from each other. For example, as described below, a plurality of output-possible frequencies that may be determined by using a clock of the processor 1510 may also be utilized in order to generate one frequency. In this case, the control signals included in the control signal wave may have periods different from each other corresponding to the plurality of output-possible frequencies. For example, as shown in FIG. 12, the control signals having periods different from each other may be included in the control signal wave. In such a case, the first time width and the second time width for each virtual signal or each control signal may be different from each other. Meanwhile, for example, a length of a first duration and/or a second duration is 10 us, virtual signals included in a virtual signal wave may be 20 in total, and thus, a total of 20 delay times may be calculated. However, as described below, among the 20 delay times, only the last N delay times may be used to determine a second frequency in the second duration. For example, the controller 1500 may calculate an average value of the last N (where N is a natural number) delay times among the delay times of the plurality of respective virtual signals and the plurality of respective output current signals corresponding to the respective virtual signals, and determine a second frequency according to whether a corresponding average value is between the first value and the second value described above, or less than the first value, or greater than the second value. In this case, the last N delay times may be integers, but may also be rational numbers including decimal points, so in such a case, the first value and the second value may also be set to rational numbers including decimal points, not integers.

Meanwhile, for example, in a case where a first frequency is output by using a combination of a plurality of output-possible frequencies as in FIG. 12, the controller 1500 may calculate an average value of the delay times of the last N (where N is a natural number) among delay times of a plurality of respective virtual signals and a plurality of respective output current signals corresponding to the respective virtual signals, regardless of periods of control signals or the virtual signals, and determine a second frequency by using the calculated average value.

In addition, an N value, which is the number of delay times for calculating the average value, may be an integer. Meanwhile, the reason why only the average value of the last N delay times is used instead of an average value of all delay times calculable in the first duration is that even though the average value of the last N delay times is used, when N is set sufficiently, the controller 1500 may calculate delay times between a first control signal wave and an output current wave quite accurately. In addition, since it takes a certain amount of time for a circuit to be stabilized due to a changed frequency after each duration starts, it may be more advantageous, in determining a frequency close to a resonant frequency of the variable load, to use the average value of only the delay times calculable after the corresponding certain amount of time.

To summarize the above description, the controller 1500 may calculate the delay times of the plurality of first virtual signals and the plurality of output current signals in at least some duration within the first duration, and determine the second frequency for the second duration on the basis of the average value of the calculated delay times. In this case, the at least some duration may be duration corresponding to the last N delay times.

However, the exemplary embodiment described in present specification is not limited to the determining of the second frequency for the second duration on the basis of the average value of the generated delay times. For example, the controller 1500 may calculate delay times of a plurality of first virtual signals and a plurality of output current signals in at least some duration within a first duration, and determine a second frequency for a second duration on the basis of a mode of the calculated delay times. In this case, the at least some duration may be duration corresponding to the last N delay times. For example, among the calculated delay times, a delay time with the largest number of identical values may be determined as a delay time in the first duration. Here, the identical values may be considered as the same value when these identical values are identical up to an X-th decimal point.

Meanwhile, when the controller 1500 determines a second frequency, at least one output-possible frequency that may be determined by using a clock of the processor 1510 may be further considered. As described above, a method for determining the second frequency by further considering the at least one output-possible frequency will be described in detail below.

When determining a second frequency, the controller 1500 may output a second control signal wave for controlling a second AC voltage having the second frequency to be applied to the load (i.e., to be output from the inverter 1300) during a second duration and apply the second control signal wave to the inverter 1300 in S625. Meanwhile, the controller 1500 may also determine the second frequency by further considering at least one output-possible frequency, and may accordingly output a corresponding second control signal wave. The detailed operation of the controller 1500 in the corresponding case follows the description of FIG. 11 described below.

Meanwhile, in the above-described description, with respect to step S720 of FIG. 7, there is disclosed a method of determining, by the controller 1500, whether to determine the second frequency to be higher than the first frequency, or whether to determine the second frequency to be lower than the first frequency, or whether to maintain the second frequency equal to the first frequency, when the controller 1500 determines the second frequency.

In this regard, additionally, a description will be provided in detail regarding how much higher the second frequency will be than the first frequency in the case when the controller 1500 determines that the second frequency is higher than the first frequency, or how much lower the second frequency will be than the first frequency in the case when the controller 1500 determines that the second frequency is lower than the first frequency.

In other words, the exemplary embodiments described below describe a method for the controller 1500 to determine a gap, a difference, or a distance between a first frequency and a second frequency in a process of step S720.

The controller 1500 may use a delay time determined in step S715 so as to determine a second frequency. In this case, when a method of calculating a delay time is expressed in an equation, this method is shown in [Equation 1] below.

[Equation 1]

$$td\_count_{curr} = (the\ number\ of\ 1st\ CLK\ count - the\ number\ of\ 2nd\ CLK\ count)$$

Here, $td\_count_{curr}$ is a delay time, "the number of 1st CLK count" is a counting value of a wave of a virtual signal according to a clock of the processor 1510 for a period corresponding to a frequency of an AC voltage being output in a first duration and is a first counting value which is a counting value from a rising edge of the wave of the virtual signal to a first falling edge thereof appearing after the corresponding rising edge, and "the number of 2nd CLK count" is a second counting value which is a counting value from the rising edge of the wave of the virtual signal to a falling edge of a wave of an output current.

When determining $td\_count_{curr}$ through [Equation 1], the controller 1500 may determine a second frequency to be lower than a first frequency in a case where $td\_count_{curr}$ is less than the first value, and may determine a second frequency to be higher than the first frequency in a case when $td\_count_{curr}$ exceeds the second value. In a case when $td\_count_{curr}$ is greater than or equal to the first value and less than or equal to the second value, the second frequency will be determined to be the same as the first frequency.

In a case when the controller 1500 determines that the second frequency is higher or lower than the first frequency, a third counting value may be determined by using the following [Equation 2] and the first frequency, which is the frequency of the first control signal or the first AC voltage output in the first duration, and counting the first frequency using a clock of the processor 1510. Here, counting the frequency using the clock of the processor 1510 means counting a time corresponding to a period, which is the reciprocal of a frequency, according to the clock of the processor 1510, and a counting method may be applied in the same manner as described above.

[Equation 2]

$$First\ frequency = \frac{CLK}{the\ number\ of\ 3rd\ CLK\ count}$$

Here, CLK is a clock of the processor 1510, and "the number of 3rd CLK count" is a third counting value obtained by counting a first frequency using the clock of the processor 1510.

For example, when the clock of the processor 1510 is 200 MHz and the first frequency is 2 MHz, the controller 1500 may determine the third counting value as 100 since 200 * 10^6 / 100 = 2 * 10^6 = 2 MHz.

The controller 1500 may determine, as a candidate frequency, a frequency that may be generated by using a counting value within a certain range for the third counting value among a plurality of output-possible frequencies that can be output according to the clock of the processor 1510.

For example, when the controller 1500 determines a second frequency to be higher than a first frequency, a candidate frequency may be determined according to [Equation 3] below.

[Equation 3]

$$Candidate\ frequency = \frac{CLK}{the\ number\ of\ 3rd\ CLK\ count - k}$$

In contrast, when it is determined that a second frequency is lower than a first frequency, a candidate frequency may be determined according to [Equation 4] below.

[Equation 4]

$$Candidate\ frequency = \frac{CLK}{the\ number\ of\ 3rd\ CLK\ count + k}$$

Here, a k value may be a natural number, and a predetermined value may be used therefor. For example, k may be 1.

For example, according to the example described above, it may be assumed that a third counting value is 100 and a clock of the processor 1510 is 200 MHz. When the controller 1500 determines that a second frequency is higher than a first frequency and k = 1, a candidate frequency may be determined as 200 MHz / (100 - 1) = 2.02 MHz according to [Equation 3].

In contrast, when the controller 1500 determines a second frequency to be lower than a first frequency and k = 1, a candidate frequency may be determined as 200 MHz / (100 + 1) = 1.98 MHz according to [Equation 4].

Here, since the controller 1500 determines how much to increase or decrease a first frequency, the controller 1500 may subtract the first frequency according to [Equation 2] from the candidate frequency according to [Equation 3] or [Equation 4], and define a corresponding value as a delta frequency. That is, the delta frequency is a value obtained by subtracting the first frequency from the candidate frequency.

For example, a delta frequency may be expressed according to [Equation 5] as follows.

[Equation 5]

$$\Delta f_{curr/clk} = \left( fcurr + \Delta f_{curr/clk} \right) - fcurr =$$

$$\frac{CLK}{the\ number\ of\ 3rd\ CLK\ count \pm k} - \frac{CLK}{the\ number\ of\ 3rd\ CLK\ count}$$

As described above, in a case where the controller 1500 intends to increase a first frequency to determine a second frequency, a value of -k may be used, and in a case where the controller 1500 intends to decrease a first frequency to determine a second frequency, a value of +k may be used. In addition, $\Delta f_{curr/clk}$ means a delta frequency, and $f_{curr}$ means a first frequency.

Meanwhile, in order to adaptively determine the second frequency according to the delay time determined in [Equation 1], the controller 1500 may determine a smoothing factor m using a delay time according to [Equation 6] below.

In other words, in order to adaptively determine a second frequency according to a difference between a wave of a virtual signal and a wave of an output current and/or according to the driving mode in which the controller 1500 operates, the controller 1500 may determine a smoothing factor m using the delay time according to [Equation 6] below.

[Equation 6]

$$m = td\_count_{curr} / td\_count_{max}$$

Here, as described above, $td\_count_{curr}$ means a delay time. Meanwhile, $td\_count_{max}$ is a preset parameter value and may be a value stored in the controller 1500. For example, $td\_count_{max}$ may be set as an integer value.

In addition, the $td\_count_{max}$ value may be changed according to a user's input or command, and may also be changed according to the determination of the controller 1500. However, in the exemplary embodiment of the present specification, it is assumed and described that $td\_count_{max}$ is a preset fixed value.

The controller 1500 may finally determine how much to increase or decrease the first frequency so as to determine the first frequency as the second frequency by multiplying the delta frequency according to [Equation 5] by the smoothing factor m according to [Equation 6].

That is, the amount of frequency to be increased or decreased by the controller 1500 may be determined according to [Equation 7].

[Equation 7]

$$\pm \Delta f = \Delta f_{curr/clk} \times m$$

In other words, the controller 1500 may determine the second frequency by adding or subtracting Δf to the first frequency.

For example, in a case where a first frequency is 2 MHz, a delay time is 2, and the controller 1500 determines to increase the first frequency so as to determine a second frequency, a clock of the processor 1510 is 200 MHz, so $\Delta f_{curr/clk}$ = {200 MHz / (100 - 1)} - {200 MHz / 100} = 0.02 MHz (where k = 1) and m = 2 / 100 (where 100 is a fixed value), whereby Δf becomes 0.02 x 0.02 = 0.0004 MHz. Accordingly, the second frequency may be determined as (2 + 0.0004) = 2.0004 MHz.

Meanwhile, in a case where the controller 1500 uses a delay time, which is for determining a second frequency, as an average value of the last N delay times among delay times between a plurality of virtual signals and a plurality of output current signals, which may be generated in a first duration, the corresponding average value may be used as $td\_count_{curr}$.

In a case when the average value is a rational number including a decimal point, the corresponding average value as it is may be used as $td\_count_{curr}$, or a value obtained by rounding the corresponding average value up, down, or, down to an M-th decimal point may be used as $td\_count_{curr}$. Accordingly, $td\_count_{curr}$ may be a rational number including a decimal point. However, it is not limited thereto, and $td\_count_{curr}$ may also be an integer value rounded down or up from a first decimal place of the corresponding average value depending on factors such as the convenience of calculation, an operating environment of the RF generator 1000, and a tolerance range between a resonant frequency of the load and the second frequency.

Meanwhile, the controller 1500 determines the second frequency according to the above-described description, but the corresponding second frequency may be a frequency unable to be generated by the clock of the processor 1510. Accordingly, in such a case, how the controller 1500 determines and generates the second frequency may be problematic, so this will be described in detail below.

The method of generating a second frequency described below has been mentioned in relation to step S720 of FIG. 7. That is, the method of generating the second frequency described below relates to a method of determining and generating a second frequency by further considering at least one output-possible frequency in addition to the first frequency and the clock of the processor 1510 described above.

Meanwhile, as described above, a third frequency output in a third duration and a first frequency may also be generated according to the method described below. For example, when the first frequency is not included in at least one output-possible frequency, the controller 1500 may output a first AC voltage having the first frequency by using the plurality of output-possible frequencies (e.g., not only the closest output-possible frequency larger than the first frequency but also the closest output-possible frequency smaller than the first frequency) that are close to the first frequency among the at least one output-possible frequency, as in the following method.

The following [Table 3] shows output-possible frequencies that may be output using a clock of the processor 1510 when the clock of the processor 1510 is 200 MHz.

[Table 3]

| Clock of processor 1510 | Clock count | Voltage frequency of RF | Difference with next frequency |
|---|---|---|---|
| 200,000,000 | 60 | 3,333,333 | 54, 645 |
| 200,000,000 | 61 | 3,278,689 | 52,882 |
| 200,000,000 | 62 | 3,225,806 | 51,203 |
| 200,000,000 | 63 | 3,174,603 | 49, 603 |
| 200,000,000 | 64 | 3,125,000 | 48,077 |
| 200,000,000 | 65 | 3,076,923 | 46, 620 |
| 200,000,000 | 66 | 3,030,303 | 45,228 |
| 200,000,000 | 67 | 2,985,075 | 43,898 |
| 200,000,000 | 68 | 2,941,176 | 42, 626 |
| 200,000,000 | 69 | 2,898,551 | 41,408 |
| 200,000,000 | 70 | 2,857,143 | 40,241 |
| 200,000,000 | 71 | 2,816,901 | 39,124 |
| 200,000,000 | 72 | 2,777,778 | 38,052 |
| 200,000,000 | 73 | 2,739,726 | 37,023 |
| 200,000,000 | 74 | 2,702,703 | 36,036 |

Referring to the above-described [Table 3], even when the controller 1500 determines a second frequency to be 3 MHz, the second frequency of 3 MHz is actually unable to be generated with the clock of the processor 1510. In other words, referring to [Table 3], in a case where a clock count value is 66, a frequency of 3.03 MHz may be generated, and in a case where a clock count value is 67, a frequency of 2.98 MHz may be generated, so it is impossible to generate the frequency of exactly 3 MHz with just a single count value.

However, since the resonant frequency of the load does not vary in consideration of the clock of the processor 1510, there is required a method capable of generating a frequency as close as possible to the resonant frequency of the varying load with the limited clock of the processor 1510.

For example, in a case where a quality factor of the load driven by the RF generator 1000 is high, magnitudes and phases of the output current of the inverter 1300 may change more steeply depending on frequencies. Accordingly, in order to track the resonant frequency of the varying load more quickly, it is required to be able to more precisely control and output a frequency. Meanwhile, here, the case where the quality factor of the load is high may be, for example, a situation where a large flux of plasma is discharged.

23

To this end, referring to FIG. 11, there will be described a method of generating a frequency that is as close as possible to a resonant frequency of a load by using output-possible frequencies that may be output as a clock of the processor 1510. As described above, series of processes described on the basis of FIG. 11 may be viewed as a further specified example of step S720.

Accordingly, the series of processes S1105 to S1135 described with reference to FIG. 11 may be performed during processes corresponding to S720 to S725 in FIG. 7.

Referring to FIG. 11, the controller 1500 may determine a second frequency on the basis of a first frequency and a delay time according to the above-described method(S1105, S720).

The controller 1500 determines whether or not the second frequency is included in output-possible frequencies that may be output according to a clock of the processor 1510(S1110). In a case when the determined second frequency is included in the output-possible frequencies that may be output according to the clock of the processor 1510, the controller 1500 may output a wave of a second control signal that controls a second AC voltage having the second frequency, so as to be output by the inverter 1300 (i.e., to be applied to the load) during a second duration as described above (S1115, S725).

In a case when the determined second frequency is not included in the output-possible frequencies that may be output according to the clock of the processor 1510, a plurality of output-possible frequencies closest to the second frequency may be selected among the output-possible frequencies in step S1120. In this case, the number of output-possible frequencies to be selected by the controller 1500 may be determined according to a predefined setting, or the controller 1500 may select the number of output-possible frequencies that may be used to generate a frequency closest to the second frequency by combining the number of cases.

For example, when it is possible to generate a close frequency, having a difference of less than or equal to a predetermined value, from the second frequency by using a first output-possible frequency largest and closest to the second frequency and a second output-possible frequency smallest and closest to the second frequency, the controller 1500 may select two output-possible frequencies. In a case when the selecting of four output-possible frequencies may generate frequencies closer to the second frequency than the selecting of the two output-possible frequencies, then two first output-possible frequencies closest and largest to the second frequency and two second output-possible frequencies closest and smallest to the second frequency may be selected.

However, since the frequencies close to the second frequency may be generated only when the output-possible frequencies closest and largest to the second frequency and the output-possible frequency closest and smallest to the second frequency are selected among the plurality of output-possible frequencies, it may be preferable to select an even number of output-possible frequencies.

The controller 1500 may perform step S1125 of determining difference values between the second frequency and each of the plurality of closest output-possible frequencies selected. For example, when the plurality of two closest output-possible frequencies is selected, not only a first difference value between the second frequency and the closest and largest first output-possible frequency but also a second difference value between the second frequency and the closest and smallest second output-possible frequency may be determined.

The controller 1500 may determine output counts for each of the plurality of closest output-possible frequencies on the basis of a ratio of the difference values (S1130) . For example, a difference value between a first output-possible frequency and a second output-possible frequency or a third difference value which is a sum of the first difference value and the second difference value may be determined, and the output counts of each of the first output-possible frequency and the second output-possible frequency may be determined on the basis of a ratio between (a first difference value / a third difference value) and (a second difference value / a third difference value).

The controller 1500 may output a plurality of third control signals so that each of the plurality of closest output frequencies may be output as evenly as possible during a second duration according to the determined output counts. For example, the controller 1500 may output at least one third control signal corresponding to the first output-possible frequency and one or more third control signals corresponding to the second output-possible frequency to the inverter 1300 as evenly as possible during the second duration according to the number of respective correspondences(S1135). It is apparent to those skilled in the art that in a case when step S1135 is performed, step S725 will be omitted or replaced by step S1135. That is, when the second frequency is not included in the plurality of output-possible frequencies, the controller 1500 may output the plurality of third control signals instead of the wave of the second control signal.

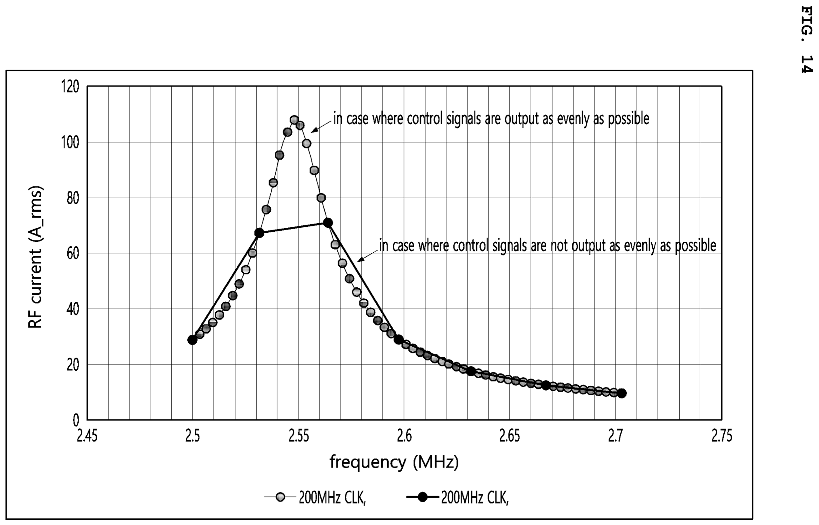

Meanwhile, it may be observed that an output current with an ideal frequency closer to a second frequency is sensed in a case where the controller 1500 outputs at least one third control signal corresponding to a first output-possible frequency and one or more third control signals corresponding to a second output-possible frequency as evenly as possible than in a case where the controller 1500 first outputs at least one third control signal corresponding to the first output-possible frequency among the plurality of closest output-possible frequencies according to the number of correspondences, and then later outputs one or more third control signals corresponding to the second output-possible frequency according to the number of correspondences. The detailed effects of this will be described below with reference to FIG. 14.

Meanwhile, here, the meaning of outputting the third control signals corresponding to the plurality of closest output-possible frequencies as evenly as possible may be interpreted as one of the following definitions.

Firstly, it may mean that dispersion between the third control signals respectively corresponding to the plurality of closest output-possible frequencies is output so as to be uniform.

Secondly, it may mean that deviation between the third control signals respectively corresponding to the plurality of closest output-possible frequencies is output so as to be maximum.

Thirdly, it may be meant to perform control where among the third control signals respectively corresponding to the plurality of closest output-possible frequencies, two of the third control signals corresponding to the largest number of output-possible frequencies are respectively arranged at the beginning position and end position of one set, and the third control signals according to the remaining output-possible frequencies are arranged alternately in the middle positions thereof, so as to output a plurality of sets generated by the above-described method in sequence. In this case, when the largest number of times is odd, one or more sets that may be generated with the corresponding number of times may be generated, and the remaining third control signals corresponding to the output-possible frequencies of the corresponding number of times as many as the remaining number may be arranged alternately in middle positions with the third control signals according to the remaining output-possible frequencies.

Fourthly, the final one may mean that a difference between averages of distances measured for each pair of the third control signals respectively corresponding to the plurality of closest output-possible frequencies is the minimum. For example, when there are third control signals corresponding to four output-possible frequencies, it may be that differences among average distances are minimal, the average distances including: an average distance between at least one third control signal corresponding to a first output-possible frequency and one or more third control signals corresponding to a second output-possible frequency; an average distance between at least one third control signal corresponding to the first output-possible frequency and at least one third control signal corresponding to a third output-possible frequency; an average distance between at least one third control signal corresponding to the first output-possible frequency and one or more third control signals corresponding to a fourth output-possible frequency; an average distance between one or more third control signals corresponding to the second output-possible frequency and at least one third control signal corresponding to the third output-possible frequency; an average distance between at least one third control signal corresponding to the second output-possible frequency and one or more third control signals corresponding to the fourth output-possible frequency; and an average distance between at least one third control signal corresponding to the third output-possible frequency and one or more second control signals corresponding to the fourth output-possible frequency.

Now, an example about a method for precisely controlling a frequency by using output-possible frequencies according to a clock of the processor 1510 will be described according to the description of FIG. 11 described above. The following description is merely an example for facilitating the understanding of the description. Accordingly, the following description should be used only to aid understanding, and the scope of the present disclosure is not limited to these examples.

As shown in [Table 3], when a clock of the processor 1510 is 200 MHz and a second frequency determined by steps S705 to S720 is 3.0 MHz, as may be seen in [Table 3], a frequency of 3.0 MHz is unable to be generated regardless of which clock count value is used, so it is difficult to achieve precise frequency control. Accordingly, in such a case, the controller 1500 utilizes a table or list, which is prestored in the controller 1500 as shown in [Table 3], or selects 3.03 MHz (corresponding to the clock count 66) and 2.98 MHz (corresponding to the clock count 67), which are frequencies closest to 3.0 MHz and capable of being generated with a 200 MHz clock, through performing calculation by the controller 1500.

The controller 1500 determines a first difference value = (3.03 - 3.0) = 0.03 MHz, a second difference value = (3.0 - 2.98) = 0.02 MHz, and a third difference value = (3.03 - 2.98) = (0.03 + 0.02) = 0.05 MHz. Since (the first difference value / the third difference value) = (0.03 / 0.05) = 0.6 and (the second difference value / the third difference value) = (0.02 / 0.05) = 0.4, the controller 1500 outputs at least one third control signal corresponding to the frequency of 3.03 MHz and one or more third control signals corresponding to the frequency of 2.98 MHz in a ratio, where the number of third control signals of 3.03 MHz : the number of third control signals of 2.98 MHz = 2 : 3. Meanwhile, in order to generate a frequency closer to 3.0 MHz more precisely, the controller 1500 outputs the at least one third control signal corresponding to the frequency of 3.03 MHz and one or more third control signals corresponding to the frequency of 2.98 MHz at the ratio of 2 : 3, but outputs these signals to be distributed as evenly as possible.

As in the example described above, an example of outputting the third control signals corresponding to frequencies of 3.03 MHz and 2.98 MHz by distributing the third control signals as evenly as possible may be seen in FIG. 12. Since frequency is the reciprocal of period, 335 ns corresponds to 2.98 MHz, and 330 ns corresponds to 3.03 MHz. Referring to FIG. 12, it may be seen that the at least one third control signal corresponding to the frequency of 3.03 MHz and one or more third control signals corresponding to the frequency of 2.98 MHz are output alternately, but at the ratio of 2 : 3.

In other words, FIG. 11 shows that the third control signals, consisting of a set of {2.98 - 3.03 - 2.98 - 3.03 - 2.98}, are repeatedly output during a second duration.

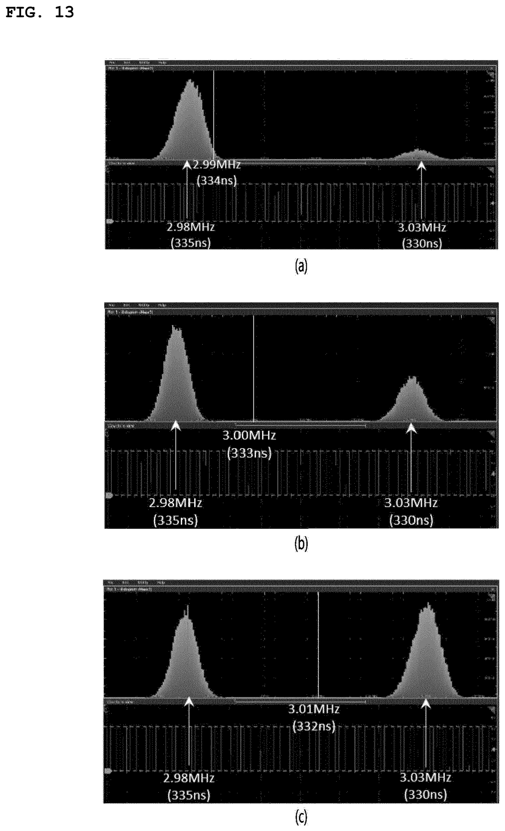

FIGS. 13 shows experimental results on the degree to which each frequency is precisely controlled, in a case where each frequency is output as in FIG. 12 versus in a case where it is not. Referring to FIGS. 13, it may be seen that when each frequency of 2.98 MHz and each frequency of 3.03 MHz are output as evenly as possible at an appropriate ratio as in FIG. 13(b), each frequency of 3.00 MHz is generated. However, as shown in FIG. 13(a), it may be seen that when a frequency of 2.98 MHz is output more than the appropriate ratio, a frequency smaller than 3.00 MHz is generated, and as shown in FIG. 13(c), when a frequency of 3.03 MHz is output more than the appropriate ratio, a frequency larger than 3.00 MHz is generated.

FIG. 14 shows experiment results obtained by comparing a case where third control signals of 2.98 MHz frequency and third control signals of 3.03 MHz frequency are output as evenly as possible at the appropriate ratio and a case where the third control signals are output at the appropriate ratio but not evenly. Referring to FIG. 14, it may be seen that an output current of the inverter 1300, measured in the case where the third control signals of 2.98 MHz frequency and the third control signals of 3.03 MHz frequency are output as evenly as possible at the appropriate ratio, is output with a waveform close to an ideal waveform. However, it may be seen that an output current of the inverter 1300, measured in the case where the third control signals of 2.98 MHz frequency and the third control signals of 3.03 MHz frequency are output at the appropriate ratio but not evenly does not form the ideal waveform.

Hereinafter, the present disclosure will describe not only an example of a structure of the control signal output unit 1570 that outputs a wave of a second control signal for controlling a second AC voltage having a second frequency to be applied to a load according to FIG. 7, but also other examples in which a frequency is precisely controlled by using such a structure.

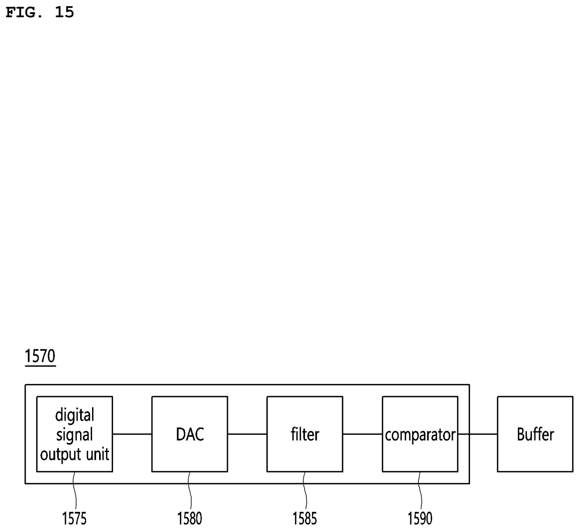

FIG. 15 shows an example of a structure of the control signal output unit 1570. Referring to FIG. 15, the control signal output unit 1570 may include a digital signal output unit 1575, a Digital to Analog Converter (DAC) 1580, a filter 1585, and a comparator 1590.

The digital signal output unit 1575 may output a bit sequence of a preset size according to a second frequency and/or a jump step, which are determined by a frequency determination unit 1550. For example, when a preset size is 4, the digital signal output unit 1575 may output 4 bits. In addition, the digital signal output unit 1575 may output a bit sequence of a preset size at each time corresponding to a clock of a processor 1510. For example, when the clock of the processor 1510 is 5 ns corresponding to a frequency of 200 MHz, the digital signal output unit 1575 may output a bit sequence every 5 ns on the basis of the jump step. Here, a method of determining a jump step and a method of outputting, by the digital signal output unit 1575, a bit sequence according to the jump step will be described in detail below. In addition, the digital signal output unit 1575 may be a Direct Digital Synthesizer (DDS), but is not limited thereto. Any device capable of outputting a bit sequence of a preset size according to a clock of the processor 1510 may be used as the digital signal output unit 1575.

Meanwhile, the digital signal output unit 1575 may map $2^n$ points to respective values (e.g., bit sequences) for the $2^n$ points and store the mapped results. Here, the respective values for the $2^n$ points may represent magnitude values of a reference sinusoidal wave at a time when respective points are arranged, assuming that the $2^n$ points are arranged at equal intervals on a time axis within one period of the reference sinusoidal wave. Here, the reference sinusoidal wave may correspond to a clock frequency of the processor 1510. For example, when a clock of the processor 1510 has a frequency of 200 MHz (i.e., a period of 5 ns), it may be assumed that the reference sinusoidal wave is a sinusoidal wave with a period of 5 ns. However, the reference sinusoidal wave is not necessarily limited to a sinusoidal wave having the clock frequency of the processor 1510, and may also be a sinusoidal wave that is set arbitrarily.

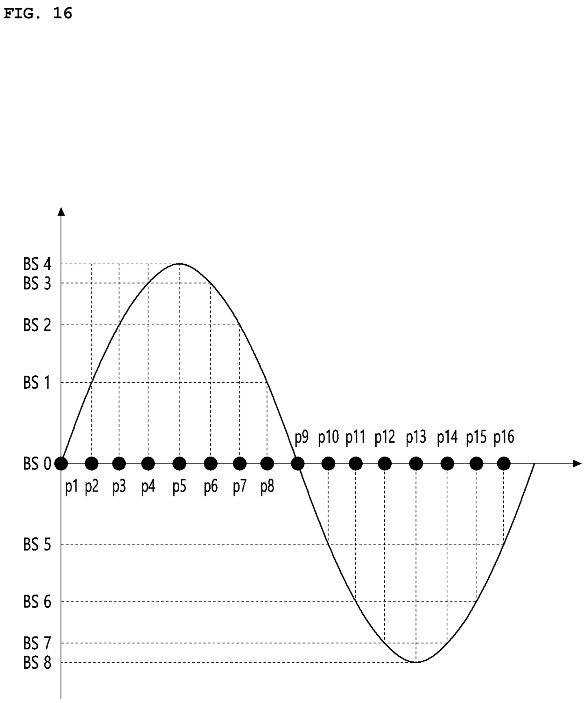

Through FIG. 16, a more detailed description of the $2^n$ points and the respective values mapped to the $2^n$ points, which are stored in the digital signal output unit 1575, will be provided.

FIG. 16 shows 16 points p1 to p16 arranged at equal intervals on a time axis within one period of a reference sinusoidal wave, when n = 4. Magnitude values (i.e., BS0 to BS8) of the reference sinusoidal wave at respective 16 time points p1 to p16 equally spaced may be mapped to the respective relevant points and stored in the digital signal output unit 1575. For example, referring to FIG. 16, p1 and p9 may be mapped to a value of BS0 and stored, p2 and p8 may be mapped to a value of BS1 and stored, p3 and p7 may be mapped to a value of BS2 and stored, and the remaining points may also be mapped to their corresponding BS values and stored. Here, BS may mean a bit sequence to be output from the digital signal output unit 1575. That is, the digital signal output unit 1575 may store respective points by mapping the magnitude values of the reference square wave corresponding to the respective points in a form of bit sequence. However, the values mapped to the respective points are not necessarily required to be mapped and stored in the form of a bit sequence, and may be stored in another form corresponding to the bit sequence output by the digital signal output unit 1575. In addition, the size of the bit sequence output by the digital signal output unit 1575 may be n, but is not necessarily limited thereto. For example, the size of the bit sequence output by the digital signal output unit 1575 may be less than or equal to n.

The DAC 1580 may receive a bit sequence output from the digital signal output unit 1575 and generate an analog signal on the basis of the bit sequence. Meanwhile, since the bit sequence is output for each time corresponding to the clock of the processor 1510, the DAC 1580 may also output the analog signal of the same size for each time corresponding to the clock of the processor 1510. For example, when a clock of the processor 1510 is 5 ns and a value of a bit sequence received from the digital signal output unit 1575 is 1, the DAC 1580 may output an analog signal having a magnitude of 1 during 5 ns.

The filter 1585 may remove a specific frequency band from an analog signal output from the DAC 1580. For example, the filter 1585 may be a low pass filter (LPF) capable of removing high frequency components from the analog signal output from the DAC 1580 and leave only low frequency components. Accordingly, the filter 1585 may convert the analog signal output from the DAC 1580 into an analog signal in the form of a sinusoidal wave. That is, the filter 1585 smooths the envelope of the analog signal output from the DAC 1580. Here, the analog signal in the form of the sinusoidal wave is not necessarily interpreted as an analog signal in the form of a perfect sinusoidal wave. That is, the analog signal in the form of the sinusoidal wave is a signal in the form of a sine or cosine wave having a smoother envelope obtained by passing through a low pass filter that removes high frequency components.

The comparator 1590 compares a magnitude of an analog signal in the form of the sinusoidal wave output from the filter 1585 with a specific value (e.g., 0), so as to output a signal having a magnitude of +A when the magnitude of the analog signal is greater than the specific value, and output a signal having a magnitude of 0 or -B when the magnitude of the analog signal is less than the specific value.

An output signal output from the comparator 1590 is used as a control signal. That is, the comparator 1590 outputs the control signal or a control signal wave for turning on/off switches (e.g., four switches) included in the inverter 1300.

Meanwhile, as shown in FIG. 5 and FIG. 15, a wave of a control signal output from the comparator 1590 may be input to the switches included in the inverter 1300 through a buffer.

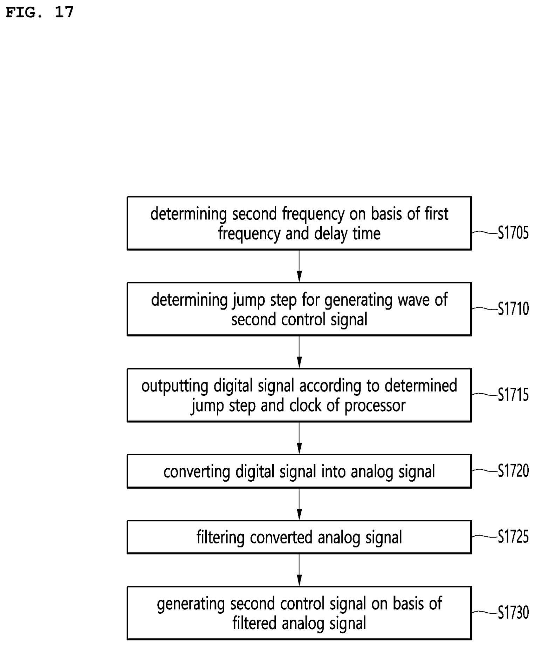

On the basis of the example of the structure of the control signal output unit 1570 described through FIGS. 15 and 16, an example of generating a wave of a control signal for outputting a second AC voltage having a second frequency determined according to a frequency determination unit 1550 is described through FIGS. 17 to 20.

Referring to FIGS. 17 to 20, the frequency determination unit 1550 performs step S1705 of determining a second frequency on the basis of a first frequency and a delay time. In this case, a process, method, etc. for determining the second frequency may be applied in the same manner as described in steps S705 to S720 in FIG. 7, so a detailed description thereof will be omitted.

The frequency determination unit 1550 performs step S1710 of determining a jump step for generating a wave of a second control signal on the basis of the determined second frequency. Here, the frequency determination unit 1550 determines the jump step according to [Equation 8] below.

[Equation 8]

$$Second\ frequency = \frac{f_c \times M}{2^n}$$

Here, $f_c$ is a clock frequency of a processor 1510. M denotes a jump step. $2^n$ is the number of points stored in the digital signal output unit 1575 as described above.

For example, when the frequency determination unit 1550 determines a second frequency as 50 MHz, $f_c$ is 200 MHz, and n is 4, M may be determined as 4 (M = 4).

Meanwhile, the digital signal output unit 1575 may output a value corresponding to at least one point according to a jump step M. In this case, the digital signal output unit 1575 may perform step S1715 of outputting a value corresponding to at least one point for each clock of the processor 1510. For example, the digital signal output unit 1575 may output a magnitude value corresponding to each point in 4-point intervals. For example, when describing this point while referring to FIG. 16, the digital signal output unit 1575 may output BS0 corresponding to p1, output BS4 corresponding to p5, output BS0 corresponding to p9, and then output BS8 corresponding to p13. After the digital signal output unit 1575 outputs BS8 corresponding to p13, BS0 corresponding to p1 may be output again using a jump step of 4. That is, the digital signal output unit 1575 may output a bit sequence corresponding to each point while circulating between p1 to p16 according to determined jump steps.

In this case, the digital signal output unit 1575 may output BS0 corresponding to p1, output BS4 corresponding to p5 after 5 ns, which is a clock period of the processor 1510, output BS0 corresponding to p9 after 5 ns again, and output BS8 corresponding to p13 after 5 ns again.

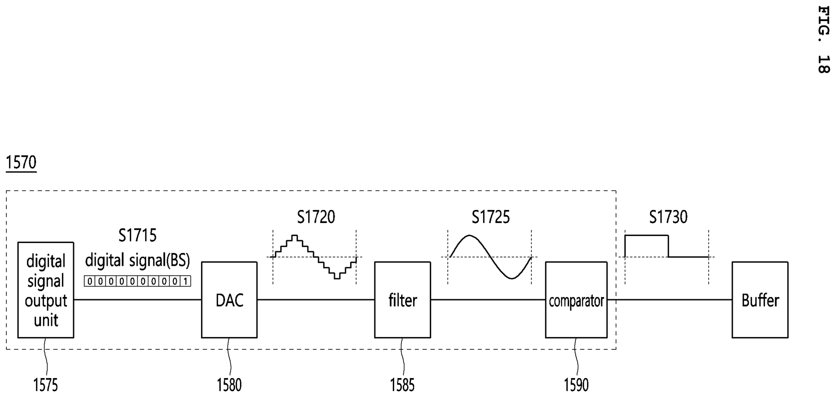

Referring to FIG. 18, it may be seen that the digital signal output unit 1575 outputs a bit sequence (BS) for each corresponding point.

A bit sequence output from the digital signal output unit 1575 may be converted into an analog signal by a DAC 1580 in step S1720. Here, since the digital signal output unit 1575 outputs the bit sequence for each clock period of the processor 1510, the analog signal converted by the DAC 1580 may also be output as an analog signal having the same value during duration corresponding to a clock period (e.g., 5 ns). For example, when the digital signal output unit 1575 outputs a bit sequence of BS4, the DAC 1580 may output an analog signal having a magnitude corresponding to the bit sequence of BS4 for 5 ns. Accordingly, as may be seen in FIG. 18, the analog signal output from the DAC 1580 has a sinusoidal wave envelope formed in a step shape, and this means that the analog signal output from the DAC 1580 includes a considerable amount of high frequency components.

The analog signal output from the DAC 1580 passes through a filter 1585 and is filtered in step S1725. As may be seen in FIG. 18, the analog signal passing through the filter 1585 has its high frequency components removed, thereby forming a smooth envelope.

The filtered analog signal is input to a comparator 1590, and the comparator 1590 may compare a magnitude of the filtered analog signal with a specific value to generate a second control signal in step S1730. Referring to FIG. 18, the second control signal output from the comparator 1590 has a second frequency determined from a frequency determination unit 1550. In addition, the second control signal operates switches (e.g., four switches) included in an inverter 1300, so as to output a second AC voltage having the second frequency from the inverter 1300.

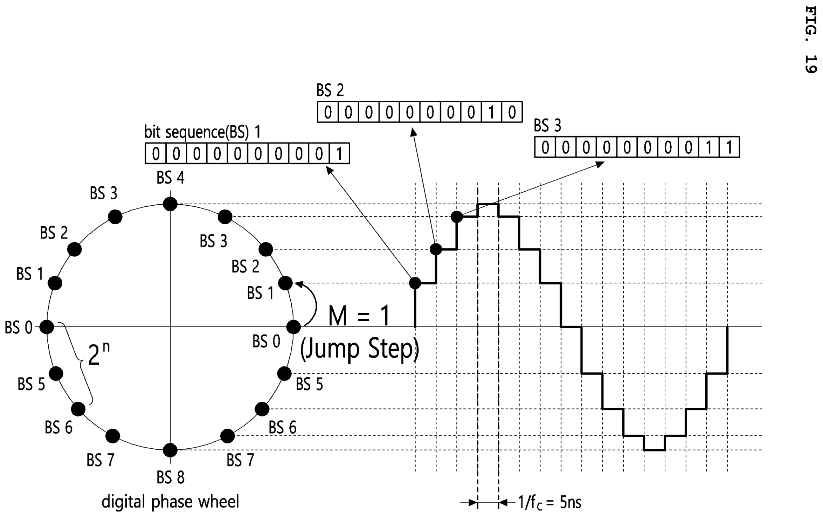

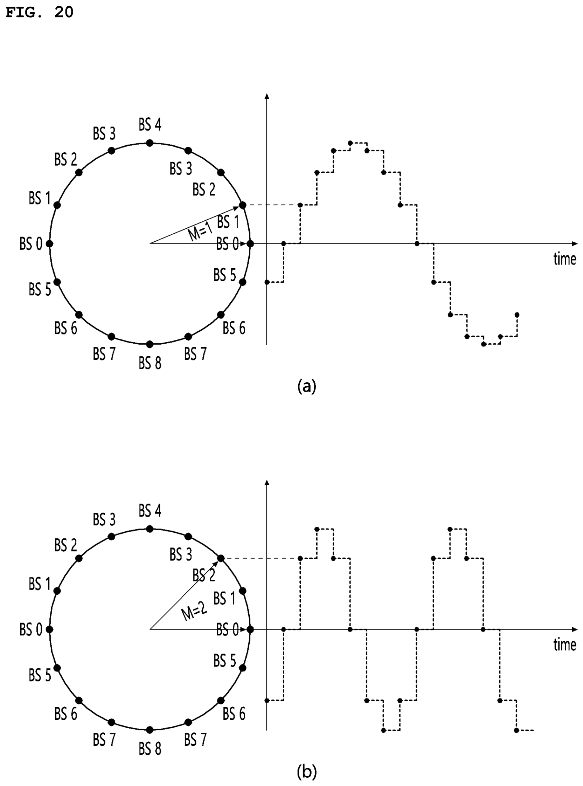

FIGS. 19 and 20 show that the digital signal output unit 1575 outputs a bit sequence according to a jump step determined from the frequency determination unit 1550, and the DAC 1580 outputs an analog signal on the basis of the output bit sequence.

Referring to FIG. 19, the digital signal output unit 1575 stores each of $2^n$ points set at equal intervals within one period of a reference sinusoidal wave as described in FIG. 17, and stores values corresponding to the respective points. It may be seen that such a storage form is expressed in the form of a digital phase wheel.

However, the values corresponding to the respective $2^n$ points may also be stored in the digital signal output unit 1575 in the form of a look-up table. For example, the $2^n$ points may be respectively mapped to the values corresponding to the respective points (e.g., BS 0 to BS 8) and stored in the form of the look-up table.

FIG. 19 shows that the frequency determination unit 1550 determines a jump step as 1. In such a case, the digital signal output unit 1575 outputs a bit sequence corresponding to each point in 1-point intervals for each clock of the processor 1510. In addition, the DAC 1580 that receives the bit sequence output from the digital signal output unit 1575 outputs an analog signal having a corresponding magnitude for each bit sequence.

Referring to FIGS. 20, it shows analog signals output from the DAC 1580 in cases where the jump step is 1 and a case where the jump step is 2. FIG. 20(a) shows an analog signal output when the jump step is 1, and FIG. 20(b) shows an analog signal output when the jump step is 2.

Comparing FIG. 20(a) and FIG. 20(b), it may be seen that a frequency of the analog signal when the jump step is 2 is twice a frequency of the analog signal when the jump step is 1. That is, it may be seen that a period of the analog signal when the jump step is 2 is half a period of the analog signal when the jump step is 1.

By controlling the jump step in this way, the period or frequency of the analog signal may be controlled, the analog signal with the controlled period or frequency may be converted into a control signal having the controlled frequency through the filter 1585 and comparator 1590, and the control signal having the controlled frequency may be applied to the switches of the inverter 1300, thereby outputting an AC voltage having the controlled frequency.

Accordingly, referring to FIG. 19, FIG. 20, and [Equation 8], when a jump step is 1, an analog signal having a frequency $1/(2^n)$ times a clock of the processor 1510 is output from the DAC 1580. In a case when a jump step is K, an analog signal having a frequency of $K/(2^n)$ times the clock of the processor 1510 is output from the DAC 1580.

Referring to this, it may be seen that the larger n is, the more precisely a frequency of an analog signal may be controlled. For example, when a clock frequency of the processor 1510 is 200 MHz and n is 4, the minimum frequency of an analog signal output from the DAC 1580 is 12.5 MHz, and a frequency of the analog signal may be controlled in units of 12.5 MHz.

In contrast, when a clock frequency of the processor 1510 is 200 MHz and n is 16, the minimum frequency of an analog signal output from the DAC 1580 is 3.052 kHz, and a frequency of the analog signal may be controlled in units of 3.052 kHz.

That is, the larger a n value, the more precisely a frequency of an analog signal output from the DAC 1580 may be controlled. In addition, the analog signal output from the DAC 1580 is converted into a second control signal through the filter 1585 and comparator 1590. In this case, the second control signal has the same frequency as the analog signal, and the frequency of the second control signal becomes the same as a frequency of an output voltage of the inverter 1300. Therefore, as the n value increases, the frequency of the output voltage may also be controlled more precisely.

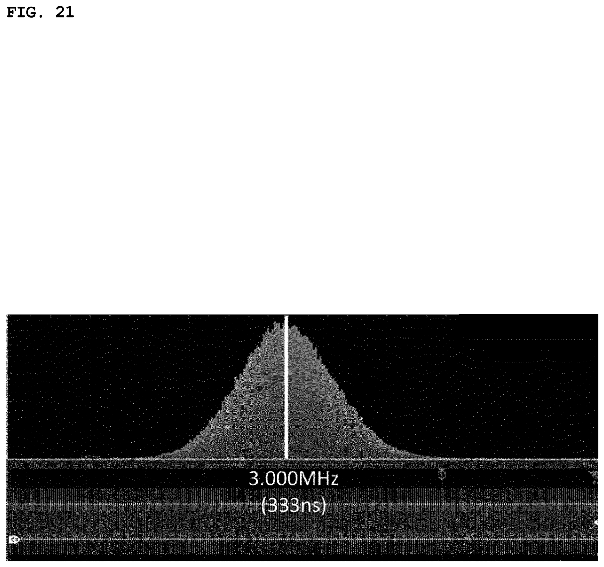

FIG. 21 shows that a clock frequency of a processor 1510 is 200 MHz (i.e., a period thereof is 5 ns), and one period of a reference sinusoidal wave is set to $2^n$ points so as to generate a frequency of 3 MHz. Here, n is greater than or equal to 32 and less than or equal to 48.

Referring to FIG. 21, a jump step is determined as I, in order to generate a frequency of 3 MHz. For example, I may be determined as 64,424,509 when n is 32, and I may be determined as 4,222,124,650,659 when n is 48. FIG. 21 shows that a digital signal output unit 1575 outputs a bit sequence corresponding to each point in I-point intervals according to a clock of the processor 1510, and a second AC voltage having a frequency of 3 MHz is generated and output according to a second control signal generated through a DAC 1580, a filter 1585, and a comparator 1590.

As shown in FIG. 21, it may be seen that the reference sinusoidal wave and the structure of the control signal output unit 1570 disclosed in FIG. 15 is divided into $2^n$ points, values corresponding to respective points are stored, and then a frequency of a sinusoidal wave is controlled by using a jump step, thereby enabling more precise frequency control.

Methods according to embodiments of the present disclosure may be implemented in the form of program instructions executable through diverse computing means and may be recorded in computer readable media. The computer-readable media may include, independently or in combination, program instructions, data files, data structures, and so on. Program instructions recorded in the media may be specially designed and configured for the embodiments or may be generally known by those skilled in the computer software art. Computer-readable recording media may include magnetic media such as hard disks, floppy disks, and magnetic tapes, optical media such as a compact disc read only memory (CD-ROM) and a digital versatile disc (DVD), magneto-optical media such as floptical disks, and hardware units, such as a read only memory (ROM), a random access memory (RAM), a flash memory, and so on, which are intentionally formed to store and perform program instructions. Program instructions may include high-class language codes executable by computers using interpreters, as well as machine language codes such as those made by compilers. The hardware units may be configured to function as one or more software modules for performing the operations according to the embodiments of the present disclosure, and vice versa.

While embodiments of the present disclosure have been shown and described with reference to the accompanying drawings thereof, it will be understood by those skilled in the art that various changes and modifications in form and details may be made therein. For example, desired results may be achieved although the embodiments of the present disclosure are performed in other sequences different from the descriptions, and/or the elements, such as a system, a structure, a device, a circuit, and so on, are combined or assembled in other ways different from the descriptions, or replaced or substituted with other elements or their equivalents.

Therefore, other implementations, other embodiments, and equivalents of the appended claims may be included in the scope of the appended claims.

[Description of the reference signs]

| 100: | Plasma system | 1000: | RF generator |
| 2000: | antenna structure | 3000: | plasma generator |

## Claims

1. A frequency control apparatus of control a frequency of AC voltage applied to a load according to a variable resonant frequency of the load, the apparatus comprising:

   an inverter having at least two switches electrically interposed between terminals electrically connected to the load and a DC power source, the inverter applies the AC voltage to the load through the terminals, wherein the AC voltage has a frequency determined by an operation of the at least two switches; and
   a controller having a processor, the controller generates a control signal controlling the operation of the at least two switches based on a clock of the processor, wherein the controller is configured to:

   output a first control signal controlling the at least two switches such that a first AC voltage having a first frequency is applied to the load during a first duration,
   assume a wave of a virtual signal corresponding to the first frequency by shifting a wave of the first control signal by a predetermined time,
   determine a delay time between the wave of the virtual signal and a wave of an output current of the inverter of the first duration in at least part of the first duration based on the clock,
   determine a second frequency based on (i) the first frequency, (ii) the delay time and (iii) at least one output-possible frequency that can be determined using the clock, and
   output a second control signal controlling the at least two switches such that a second AC voltage having a second frequency is applied to the load during a second duration immediately after the first duration.

2. The Apparatus of Claim 1, wherein the delay time is different value between a first count value and a second count value,

   wherein the first count value obtained by counting a first time length from a rising edge of the wave of the virtual signal to a falling edge of the wave of the virtual signal being firstly occurred after the rising edge, according to the clock, and
   wherein the second count value obtained by counting a second time length from the rising edge to a falling edge of the wave of the output current being firstly occurred after the rising edge, according to the clock.

3. The Apparatus of Claim 1, wherein the second frequency is increased from the first frequency when the delay time is greater than a first value,

   wherein the second frequency is decreased from the first frequency when the delay time is less than a second value,
   wherein the second frequency is the same with the first frequency when the delay time has value between the first value and the second value, and
   wherein the first value and the second value are the same or different.

4. The Apparatus of Claim 1, wherein the predetermined time is the same with time difference between a first time point at which the wave of the first control signal is input to the inverter and a second time point at which the wave of the first control signal is expected to be output from the inverter.

5. The Apparatus of Claim 1, wherein the predetermined time is less than or greater than time difference between a first time point at which the wave of the first control signal is input to the inverter and a second time point at which the wave of the first control signal is expected to be output from the inverter.

6. The Apparatus of Claim 1, wherein the controller is configured to:

   determine the second frequency based on multiplying a difference value between the first frequency and an adjacent frequency to the first frequency among the at least one output-possible frequency by a factor,
   wherein the factor is determined based on the delay time.

7. The Apparatus of Claim 1, wherein the controller is configured to:
   determine the delay time based on an average value of a last N delay time among delay times between the wave of the output current and the wave of the virtual signal, both of which can be obtained during the first duration.

8. The Apparatus of Claim 1, wherein the controller is configured to:
   when the second frequency is not included in the at least one output-possible frequency:

   determine difference values between each of a plurality of output-possible frequencies closest to the second frequency among the at least one output-possible frequency and the second frequency, and
   output a plurality of third control signals, instead of the second control signal, corresponding to each of the plurality of output-possible frequencies according to output counts for each of the plurality of output-possible frequencies, and
   wherein the output counts are determined based on a ratio between the difference values.

9. The Apparatus of Claim 8, wherein the controller is configured to:
   output the plurality of third control signals such that a dispersion among the plurality of third control signals is uniformly distributed according to the output counts for each of the plurality of output-possible frequencies.

10. A frequency control method of control a frequency of AC voltage applied to a load according to a variable resonant frequency of the load by a frequency control apparatus, the method comprising:

    outputting a first control signal controlling such that a first AC voltage having a first frequency is applied to the load during a first duration,
    assuming a wave of a virtual signal corresponding to the first frequency by shifting a wave of the first control signal by a predetermined time,
    determining a delay time between the wave of the virtual signal and a wave of an output current of the inverter of the first duration in at least part of the first duration based on a clock corresponding to the frequency control apparatus,
    determining a second frequency based on (i) the first frequency, (ii) the delay time and (iii) at least one output-possible frequency that can be determined using the clock, and
    outputting a second control signal controlling such that a second AC voltage having a second frequency is applied to the load during a second duration immediately after the first duration.

11. The method of Claim 10, wherein the delay time is different value between a first count value and a second count value,

wherein the first count value obtained by counting a first time length from a rising edge of the wave of the virtual signal to a falling edge of the wave of the virtual signal being firstly occurred after the rising edge, according to the clock, and
wherein the second count value obtained by counting a second time length from the rising edge to a falling edge of the wave of the output current being firstly occurred after the rising edge, according to the clock.

12. The method of Claim 10, wherein the second frequency is increased from the first frequency when the delay time is greater than a first value,

wherein the second frequency is decreased from the first frequency when the delay time is less than a second value,
wherein the second frequency is the same with the first frequency when the delay time has value between the first value and the second value, and
wherein the first value and the second value are the same or different.

13. The method of Claim 10, wherein the predetermined time is the same with time difference between a first time point at which the wave of the first control signal is input to the inverter and a second time point at which the wave of the first control signal is expected to be output from the inverter.

14. The method of Claim 10, wherein the predetermined time is less than or greater than time difference between a first time point at which the wave of the first control signal is input to the inverter and a second time point at which the wave of the first control signal is expected to be output from the inverter.

15. The method of Claim 10, wherein the determining the second frequency comprising:

determining the second frequency based on multiplying a difference value between the first frequency and an adjacent frequency to the first frequency among the at least one output-possible frequency by a factor,
wherein the factor is determined based on the delay time.

16. The method of Claim 10, wherein the determining the delay time comprising:
determining the delay time based on an average value of a last N delay time among delay times between the wave of the output current and the wave of the virtual signal, both of which can be obtained during the first duration.

17. The method of Claim 10, wherein the method further comprising:
when the second frequency is not included in the at least one output-possible frequency:

determining difference values between each of a plurality of output-possible frequencies closest to the second frequency among the at least one output-possible frequency and the second frequency, and
outputting a plurality of third control signals, instead of the second control signal, corresponding to each of the plurality of output-possible frequencies according to output counts for each of the plurality of output-possible frequencies, and
wherein the output counts are determined based on a ratio between the difference values.

18. The method of Claim 17, wherein the outputting the plurality of third control signals comprising:
outputting the plurality of third control signals such that a dispersion among the plurality of third control signals is uniformly distributed according to the output counts for each of the plurality of output-possible frequencies.

FIG. 1

<u>100</u>

1000 —⌐ RF generator —— antenna structure ⌐— 2000

plasma generator ⌐— 3000

**FIG. 2**

FIG. 3

FIG. 4

FIG. 5

time difference

1570

control signal | Buffer Chip | Isolator Chip | Gate driver | plurality of switches | output voltage

control signal output unit

1500

1300

**FIG. 6**

FIG. 7

| | |
|---|---|
| outputting wave of first control signal for controlling first AC voltage having first frequency to be applied to load during first duration | S705 |

| | |
|---|---|
| assuming wave of virtual signal obtained by shifting wave of first control signal by predetermined time | S710 |

| | |
|---|---|
| determining delay time between wave of virtual signal and wave of output current of inverter in first duration | S715 |

| | |
|---|---|
| determining second frequency on basis of first frequency, delay time, and at least one output-possible frequency | S720 |

| | |
|---|---|
| outputting wave of second control signal for controlling second AC voltage having second frequency to be applied to load during second duration | S725 |

FIG. 8

control signal

ideal inverter output voltage

virtual signal (fully resonant drive) (1-1) (2-1)

virtual signal (inductive drive) (1-2) (2-2)

virtual signal (capacitive drive) (1-3) (2-3)

sensed output current of inverter (3-1) (3-2) (3-3)

(4-1) (4-2) (4-3)

FIG. 9

Response
Y=1/Z [Ω⁻¹]
~RF current

micro-shift of resonance point
due to plasma tremors

increase in
RF current

frequency (f)

<in case of capacitive driving mode>

(a)

additional shift of resonance
point due to plasma
magnitude decrease

micro-shift of resonance
point due to plasma tremors

Response
Y=1/Z [Ω⁻¹]
~RF current

decrease in
RF current

additional decrease
in RF current

frequency (f)

<in case of inductive driving mode>

(b)

**FIG. 10**

FIG. 11

S1105 — determining second frequency on basis of first frequency and delay time

S1110 — is second frequency included in output-possible frequencies?

Yes

S1115

outputting wave of second control signal for controlling second AC voltage having second frequency to be applied to load during second duration

No

S1120 — selecting plurality of output-possible frequencies closest to second frequency among output-possible frequencies

S1125 — determining difference values between second frequency and each of closest plurality of output-possible frequencies

S1130 — determining number of outputs for each of closest plurality of output-possible frequencies on basis of ratio between difference values

S1135 — outputting plurality of third control signals so that each of plurality of closest output-possible frequencies can be output as evenly as possible during second duration according to number of outputs

FIG. 12

outputting alternately so that average of frequency signals (PWM) of 335 ns and 330 ns becomes 333 ns. (at this time, 335 ns and 330 ns are output so as to be distributed as evenly as possible)

FIG. 13

(a)

(b)

(c)

FIG. 14

FIG. 15

1570

| digital signal output unit | DAC | filter | comparator | | Buffer |
| --- | --- | --- | --- | --- | --- |
| 1575 | 1580 | 1585 | 1590 | | |

**FIG. 16**

FIG. 17

```
┌─────────────────────────────────────────┐
│ determining second frequency on basis of first │──S1705
│        frequency and delay time          │
└─────────────────────────────────────────┘
                    │
                    ▼
┌─────────────────────────────────────────┐
│  determining jump step for generating wave of │──S1710
│          second control signal            │
└─────────────────────────────────────────┘
                    │
                    ▼
┌─────────────────────────────────────────┐
│ outputting digital signal according to determined │──S1715
│     jump step and clock of processor      │
└─────────────────────────────────────────┘
                    │
                    ▼
┌─────────────────────────────────────────┐
│   converting digital signal into analog signal │──S1720
└─────────────────────────────────────────┘
                    │
                    ▼
┌─────────────────────────────────────────┐
│        filtering converted analog signal  │──S1725
└─────────────────────────────────────────┘
                    │
                    ▼
┌─────────────────────────────────────────┐
│ generating second control signal on basis of │──S1730
│          filtered analog signal           │
└─────────────────────────────────────────┘
```

FIG. 18

FIG. 19

EP 4 730 389 A1

FIG. 20

(a)

(b)

FIG. 21

3.000MHz
(333ns)

## INTERNATIONAL SEARCH REPORT

| International application No. |
|---|
| **PCT/KR2024/016248** |

### A. CLASSIFICATION OF SUBJECT MATTER

**H01J 37/32**(2006.01)i; **H03K 5/135**(2006.01)i; **H03K 5/1534**(2006.01)i

According to International Patent Classification (IPC) or to both national classification and IPC

### B. FIELDS SEARCHED

Minimum documentation searched (classification system followed by classification symbols)

H01J 37/32(2006.01); H01L 21/3065(2006.01); H02M 7/48(2007.01); H02M 7/5387(2007.01); H05B 41/18(2006.01); H05B 41/24(2006.01); H05H 1/46(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 플라즈마(plasma), 인버터(inverter), 주파수 제어(frequency control), 클록 (clock), 가상 신호(virtual signal), 출력 전류(output current), 지연 시간(delay time)

### C. DOCUMENTS CONSIDERED TO BE RELEVANT

| Category* | Citation of document, with indication, where appropriate, of the relevant passages | Relevant to claim No. |
|---|---|---|
| X | KR 10-2021-0136744 A (EN2CORE TECHNOLOGY, INC) 17 November 2021 (2021-11-17)<br>See paragraphs [0085]-[0088], [0122], [0143]-[0152] and [0163]; claims 1 and 7; and figure 4. | 1-18 |
| A | KR 10-2020-0077492 A (EN2CORE TECHNOLOGY, INC) 30 June 2020 (2020-06-30)<br>See claims 1-18. | 1-18 |
| A | JP 2008-109815 A (DAIHEN CORP.) 08 May 2008 (2008-05-08)<br>See claim 1. | 1-18 |
| A | JP 2004-327117 A (MATSUSHITA ELECTRIC WORKS LTD.) 18 November 2004 (2004-11-18)<br>See claims 1-16; and figures 1-5. | 1-18 |
| A | JP 6510679 B2 (SPP TECHNOLOGIES CO., LTD.) 08 May 2019 (2019-05-08)<br>See claims 1-3. | 1-18 |

☐ Further documents are listed in the continuation of Box C.　　☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 January 2025** | **15 January 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/016248**

| Patent document cited in search report | | | Publication date (day/month/year) | Patent family member(s) | | | Publication date (day/month/year) |
|---|---|---|---|---|---|---|---|
| KR | 10-2021-0136744 | A | 17 November 2021 | KR | 10-2022-0091454 | A | 30 June 2022 |
| | | | | KR | 10-2413538 | B1 | 27 June 2022 |
| | | | | KR | 10-2716837 | B1 | 15 October 2024 |
| | | | | TW | 202213926 | A | 01 April 2022 |
| | | | | WO | 2021-225411 | A1 | 11 November 2021 |
| KR | 10-2020-0077492 | A | 30 June 2020 | CN | 110546873 | A | 06 December 2019 |
| | | | | CN | 110546873 | B | 26 October 2021 |
| | | | | EP | 3644491 | A1 | 29 April 2020 |
| | | | | JP | 2020-517221 | A | 11 June 2020 |
| | | | | JP | 6931506 | B2 | 08 September 2021 |
| | | | | KR | 10-2012743 | B1 | 21 August 2019 |
| | | | | KR | 10-2019-0098122 | A | 21 August 2019 |
| | | | | KR | 10-2020-0118788 | A | 16 October 2020 |
| | | | | KR | 10-2021-0102136 | A | 19 August 2021 |
| | | | | KR | 10-2022-0073721 | A | 03 June 2022 |
| | | | | KR | 10-2024-0007700 | A | 16 January 2024 |
| | | | | KR | 10-2404403 | B1 | 02 June 2022 |
| | | | | KR | 10-2489915 | B1 | 18 January 2023 |
| | | | | KR | 10-2622535 | B1 | 09 January 2024 |
| | | | | KR | 10-2645224 | B1 | 08 March 2024 |
| | | | | US | 11258373 | B2 | 22 February 2022 |
| | | | | US | 2021-0226555 | A1 | 22 July 2021 |
| | | | | US | 2023-0318486 | A1 | 05 October 2023 |
| | | | | US | 2024-0223104 | A1 | 04 July 2024 |
| | | | | WO | 2018-236088 | A1 | 27 December 2018 |
| JP | 2008-109815 | A | 08 May 2008 | JP | 4823851 | B2 | 24 November 2011 |
| JP | 2004-327117 | A | 18 November 2004 | | None | | |
| JP | 6510679 | B2 | 08 May 2019 | CN | 108353493 | A | 31 July 2018 |
| | | | | EP | 3337300 | A1 | 20 June 2018 |
| | | | | EP | 3337300 | A4 | 05 December 2018 |
| | | | | EP | 3337300 | B1 | 25 November 2020 |
| | | | | JP | 2019-145513 | A | 29 August 2019 |
| | | | | KR | 10-2018-0116225 | A | 24 October 2018 |
| | | | | KR | 10-2746117 | B1 | 24 December 2024 |
| | | | | TW | 201732857 | A | 16 September 2017 |
| | | | | TW | I713681 | B | 21 December 2020 |
| | | | | US | 11195697 | B2 | 07 December 2021 |
| | | | | US | 2018-0315581 | A1 | 01 November 2018 |
| | | | | WO | 2017-126662 | A1 | 27 July 2017 |

Form PCT/ISA/210 (patent family annex) (July 2022)